Europäisches Patentamt

European Patent Office ·

Office européen des brevets

(11) Publication number: **0 041 870**

**B1**

(12) **EUROPEAN PATENT SPECIFICATION**

(45) Date of publication of patent specification: **30.12.86**

(21) Application number: **81302575.6**

(22) Date of filing: **10.06.81**

(51) Int. Cl.⁴: **G 03 B 41/00**

(54) Pattern position recognition apparatus.

(30) Priority: **10.06.80 JP 78235/80**
**29.12.80 JP 187258/80**

(43) Date of publication of application:
**16.12.81 Bulletin 81/50**

(45) Publication of the grant of the patent:
**30.12.86 Bulletin 86/52**

(84) Designated Contracting States:
**DE FR GB NL**

(56) References cited:
**FR-A-2 311 403**
**FR-A-2 434 535**
**US-A-3 898 617**
**US-A-3 899 634**
**US-A-4 163 212**

(73) Proprietor: **FUJITSU LIMITED**
**1015, Kamikodanaka Nakahara-ku**
**Kawasaki-shi Kanagawa 211 (JP)**

(72) Inventor: **Nakashima, Masato**
**33-18, Mitakedai Midori-ku**
**Yokohama-shi Kanagawa 227 (JP)**
Inventor: **Koezuka, Tetsuo**
**5-31-10-102, Kamimeguro Meguro-ku**
**Tokyo 153 (JP)**
Inventor: **Inagaki, Takefumi**
**1341-75, Ohzenji Tama-ku**
**Kawasaki-shi Kanagawa 215 (JP)**

(74) Representative: **Sunderland, James Harry et al**
**HASELTINE LAKE & CO Hazlitt House 28**
**Southampton Buildings Chancery Lane**
**London WC2A 1AT (GB)**

Courier Press, Leamington Spa, England.

## Description

In the manufacture of a hybrid IC or the like, an IC chip pellet is mounted on a carrier substrate, and wire bonding to the IC chip pellet is effected by automatic wire bonding apparatus.

To accomplish successful automatic wire bonding operations, when assembling semiconductor IC's or hybrid IC's it is desirable that the position of each bonding pad pattern of an IC chip should be detected both quickly and accurately. Unless the position of the pattern is detected quickly and accurately, the assembly process will be delayed or the yield of usable assembled products will decline. The position of wire bonding pattern is usually detected in the following manner.

First, an image pickup device, such as a TV camera, picks up an image of a bonding pad pattern included in an IC chip pattern. Then, from the image of the bonding pad pattern on the entire IC chip there is obtained data showing the position (axial position with respect to a reference system) of the IC pattern and data showing the rotation (angular position with respect to the reference system) of the IC pattern. Based on such data position and inclination of an IC chip and a pad thereon are identified.

Two methods are known for identifying the chip pattern of an IC.

One method involves detection of a specific electrode pattern on an IC chip, as recited on pages 168 to 174, No. 2 volume 19, Japanese Journal of Applied Physics 1980.

The other method is called a multiple local pattern matching method and is as disclosed on pages 9 to 16, No. 1, Volume 96-C, The Transactions of the Institute of Electrical Engineers of Japan (January 1976).

In the first-mentioned method, the surface of an IC chip pellet is scanned by a single TV camera, or the like. Image signals obtained in the course of such scanning are converted into binary coded signals, based on a desired threshold value. Using the binary coded signals, only the images of pads are displayed. Then, the positional relationships between, or relative positions of, a bonding pad existing at a single side of the chip and other pads existing on two other sides of the chip, which other sides are at opposite terminal ends of the aforementioned single side of the chip, are detected, thereby to determine the position of the bonding pad on the basis of the data relating to the entire chip.

In the multiple local pattern matching method, the surface of an IC pellet is also scanned by a TV camera, or the like. Image signals obtained in the course of such scanning are converted into binary coded signals having a desired threshold value. The binary coded signals representing electrode patterns are compared with image data representing one of those electrode patterns which is predetermined and whose position is known. When some of the binary-coded signals are found to be identical with the image data, the position of the predetermined electrode pattern is thereby identified and thus the position of a bonding pad is determined with respect to the position of the predetermined electrode pattern.

Both methods involve the processing of image signals obtained by scanning the entire surface of an IC pellet. The amount of data that must be processed is so large that it inevitably takes a long time to identify a chip pattern Further, the first-mentioned method cannot work if bonding pads are not arranged in orderly rows and columns. The second-mentioned method may fail to identify the predetermined electrode pattern correctly, because in most cases there will be other electrode patterns on an IC pellet very similar to the predetermined pattern to be recognised.

Generally speaking, in a conventional method of identifying the pad pattern of an IC chip, the entire IC chip is caught within a viewfield, image signals are picked up and converted into binary-coded signals having a single desired threshold value, and the position of the pad pattern is detected directly from the binary-coded signals. This method, however, is disadvantageous because an enormous amount of data must be processed, and it takes a long time to identify the pad pattern. Further, with this method it is difficult to identify a pad pattern in a case in which a plurality of pad patterns are not arranged in an orderly manner or in a case in which wire patterns having a width similar to that of the pad patterns are arranged near the pad patterns.

Further, in previously used devices for pad pattern identification, the optical signal-to-noise (S/N) ratio is inevitably small. That is, the resolution of the bonding pad pattern image is relatively low. Therefore, failure to detect the correct position of the bonding pad pattern can occur in a case in which the IC chip is displaced too far from the image pickup device. Moreover, an incorrect position for the bonding pad pattern may be identified if the bonding pads have scratches made whilst they were put to use in electrical testing of the chip to which they belong.

According to an embodiment of this invention there is provided position recognition apparatus, comprising an image pickup section for imaging an object and a pattern on the object;

characterised in that the apparatus comprises means for converting image signals output from the image pickup section and corresponding to a predetermined field of view into first binary coded signals corresponding to image signals exceeding a first threshold value appropriate for distinguishing the object,

means for detecting the absolute position and inclination of the object on the basis of the first binary coded signals;

means for converting image signals, output from the image pickup section, corresponding only to a view window smaller than and within the predetermined field of view, into second binary coded signals corresponding to image signals exceeding a second threshold value, appropriate for distinguishing the pattern, and

means for detecting the absolute position of the pattern on the basis of the second binary coded signals.

An embodiment of the present invention can provide an apparatus which can recognise the position of a pattern laid on an object with an amount of data required to be processed reduced greatly, thus enabling high speed data processing, and with the avoidance of error in the recognition of the pattern, thus achieving a clear and accurate detection of the object.

An embodiment of this invention can provide a recognition apparatus for detecting the position of a pattern on an object, using an image pickup system having a lens system, a binary-coded signal processing circuit for processing image signals supplied from the image pickup system and a system for identifying the pattern the apparatus comprising means for converting the image signals into binary-coded signals having a first threshold value, thereby detecting the absolute position and inclination of the object, means for calculating the position of a view window for identifying the pattern, from data representing the absolute position of the object and data representing the positional relationship between the object and the pattern, and means for obtaining image signals from the pattern caught in the view window and converting the image signals into binary-coded signals having a second threshold value which differs from the first threshold value.

Further an embodiment of this invention cam provide recognition apparatus for detecting the position of an object, comprising an image pickup section for picking up an image of a pattern laid on an object, a pre-treatmemt circuit for converting the outputs of the image pickup section into binary-coded signals, and a pattern detecting section for detecting the position of the pattern from the binary-coded signals produced by the pre-treatment circuit, the image pickup section being constituted by a first optical system for picking up an image of the object and a second optical system for picking up an image of the pattern.

An embodiment of this invention can provide apparatus for recognising the position of a pattern on an object, which apparatus can detect, with high speed and high optical S/N (signal-to-noise) ratio, position and inclination of an IC chip pattern, and an electrode pad pattern provided on the IC chip, thereby to permit an efficient wire bonding operation.

Reference is made, by way of example, to the accompanying drawings, in which:—

Figure 1 is a schematic diagram illustrative of an embodiment of the present invention,

Figures 2A to 2D illustrate respective images provided in the operation of an embodiment of the present invention,

Figure 3A is a block circuit diagram of circuitry for obtaining binary-coded signals having two threshold values, as employed in an embodiment of the present invention,

Figures 3B is a schematic diagram for assistance in explanation of operation of an embodiment of the present invention,

Figures 3C and 3D are respective waveform diagrams for assistance in explanation of operation of an embodiment of the present invention,

Figure 4 is a flow chart schematically illustrating operations involved in the detection of the position of a pattern by an embodiment of the present invention,

Figure 5 is a synoptic block diagram of apparatus embodying the present invention,

Figure 6 is a schematic block diagram of a memory read circuit, as employed in an embodiment of the present invention,

Figure 7 is a schematic diagram illustrating the relative positioning of a bonding pad and a view window, for assistance in explanation of an embodiment of the present invention,

Figures 8A and 8B are schematic diagrams for assistance in explanation of the detection of a chip image by an embodiment of the present invention,

Figure 9 is a schematic block diagram of a scanning circuit, for detecting the corner of a chip, used in an embodiment of the present invention,

Figures 10 to 12 are respective schematic diagrams for assistance in explanation of the determination of the position and size of a view window by an embodiment of the present invention,

Figure 13 is a schematic block diagram of a circuit for correcting for inclination in the positioning of a view window, as employed in an embodiment of the present invention,

Figures 14A and 14B are explanatory diagrams for assistance in explanation of the detection of a pad pattern by an embodiment of the present invention,

Figure 15 is a schematic block diagram of a circuit for forming a projected pattern, as used in an embodiment of the present invention,

Figure 16 is a schematic block diagram of a circuit for detecting a central point of a projected pattern, as used in an embodiment of the present invention,

Figures 17A and 17B, Figures 18A and 18B, and Figure 19 are schematic diagrams for assistance in explanation of the detection of the position of an IC chip in accordance with further embodiments of this invention,

Figure 20 is a schematic diagram for assistance in explanation of the detection of position and inclination of an IC chip, in accordance with another embodiment of this invention,

Figure 21 is a synoptic block diagram illustrating another embodiment of this invention,

Figure 22A is a schematic flow chart illustrating operations effected by apparatus embodying the present invention,

Figures 22B to 22E schematically show images provided by the apparatus for Figure 22A in the course of operation,

Figure 23 is a schematic, detailed illustration of image pickup means which can be used in the apparatus of Figure 21.

Figure 24 is a schematic block diagram illustrating parts of another embodiment of the present invention, and

Figures 25A and 25B, Figures 26A, 26B and 26C and Figures 27A and 27B are diagrams schematically illustrating respective further embodiments of the present invention.

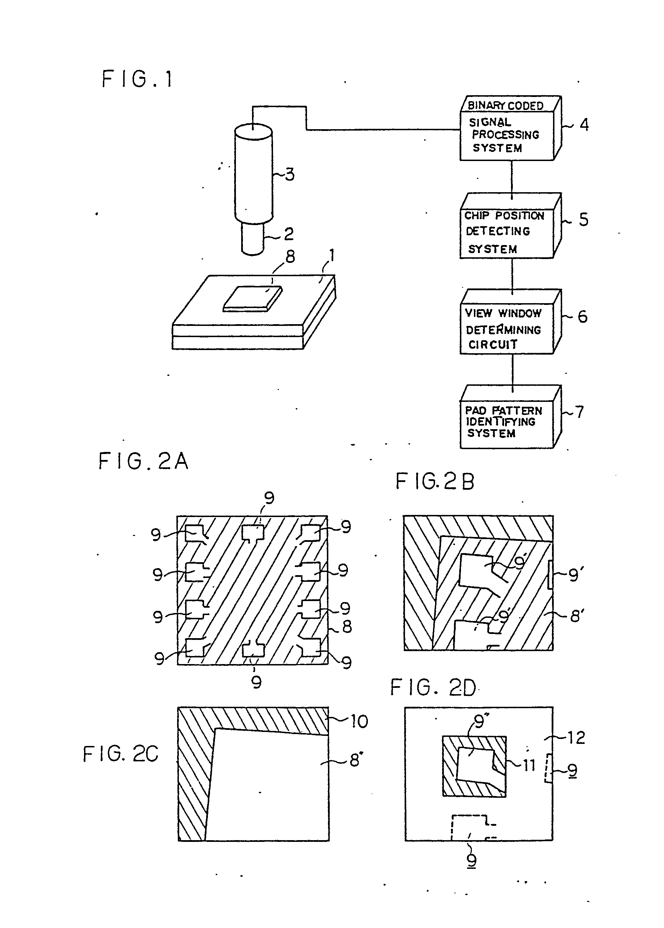

Figure 1 shows apparatus embodying the present invention for detecting the position of a pad pattern on a semiconductor IC chip. The apparatus comprises an image pickup system 3, a binary-coded-signal processing system 4, a chip position detecting system 5, a view window determining circuit 6 and a pad pattern identifying system 7. The image pickup system 3 has stage 1 and a lens system 2.

The image pickup system 3 picks up an image of a semiconductor IC chip 8 placed on the stage 1, using the lens system 2, and generates image signals. The image signals are supplied to the binary coded signal processing system 4. The system 4 converts the image signals 4 into binary-coded signals having or being subjected to a specific threshold value and representing a profile or outline of the IC chip 8. At the same time, the system 4 removes noise components from the image signals supplied from the image pickup system 3.

The binary-coded signals are supplied to the chip position detecting system 5. The system 5 detects the position of the IC chip 8 according to the binary-coded signals. The binary-coded signals are supplied further to the view window determining circuit 6. The circuit 6 is supplied also with view window size data which is read from a memory (not shown).

Using the binary-coded signals and the view window size data, the circuit 6 determines the position and size of a view window. Then, the image pickup system 3 picks up images of that or those pad patterns on the IC chip 8 which is or are caught in the view window determined by the circuit 6, and generates image signals which represent the pad pattern(s). These signals are applied to the binary-coded signal processing system 4. The system 4 converts the image signals into binary-coded signals having a specific threshold value which differs from that of the binary-coded signals representing the profile or outline of the IC chip 8. At the same time, the system 4 removes noise components from the image signals. The binary-coded signals thus generated are supplied to the pad pattern identifying system 7. Using the binary-coded signals supplied thereto, the system 7 determines the profile or outline and position of the pad pattern.

The various steps mentioned above, which arise in the course of the operation of the embodiment of the present invention, may be better understood from Figures 2A to 2D, which illustrate images as picked up in each of those steps.

Figure 2A shows an image of the IC chip 8, featuring pad patterns 9, Figure 2B is an image picked up by the image pickup system 3, showing an IC chip image 8' and pad pattern images 9'. Figure 2C shows an IC chip image 8'', as obtained by the binary-coded, signal processing system 4 (with a first specific threshold value. In Figure 2C, the blank area corresponds to the IC chip 8 and the hatched area represents the region outside the IC chip 8. Thus, Figure 2C shows a profile or outline of chip 8. Figure 2D shows a pad pattern image 9'', obtained by processing the image signals representing the pad pattern 9 into binary-coded signals having a threshold value a (a second specific threshold value different from that of the binary-coded signals representing the profile of the IC chip 8 shown in Figure 2C. In Figure 2D, a square 11 represents the view window determined by the circuit 6, a square 12 represents a surface portion of the IC chip 8 which is located outside the view window 11 and is not identified, and a pad pattern image 9'' is positioned in the identification square or view window 11.

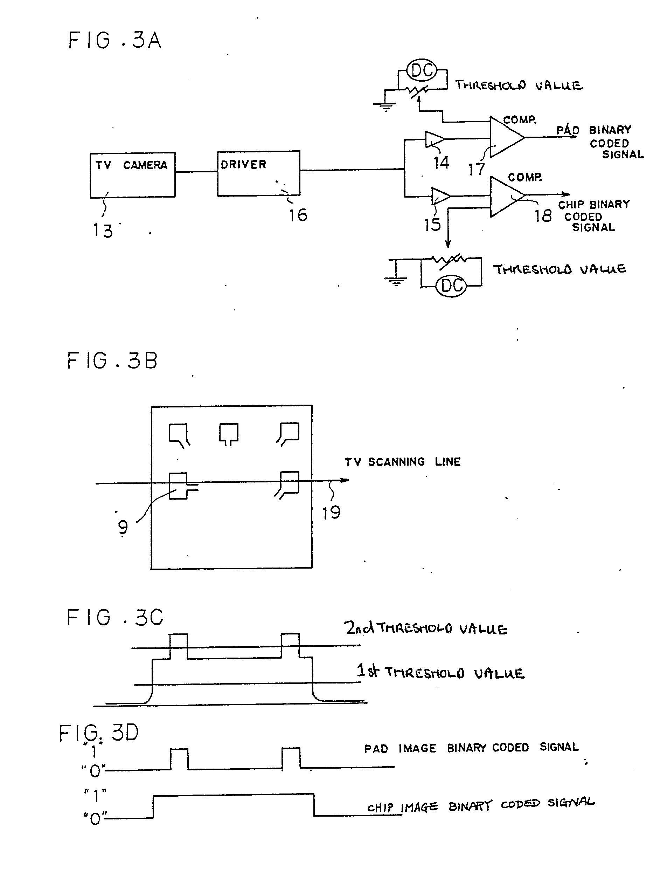

Figure 3A is a schematic circuit diagram illustrating circuitry for forming binary-coded signals based on first and second threshold values. An image signal picked up by a TV camera 13 is applied to each of two buffer amplifiers 14 and 15 through a TV driver 16. The outputs of two buffer amplifiers are input into respective comparators 17 and 18 having different threshold values and are converted onto binary-coded signals having different threshold values by the comparators 17 and 18.

Figure 3B shows an image of a chip 8 with pads 9. Figure 3C is a waveform diagram of an image signal corresponding to one scanning line 19 of the TV camera 13 as chip 8 and pads 9 are scanned. When the image signal of Figure 3C is converted into binary-coded signals using two different threshold values as indicated in Figure 3C, then a chip image binary coded signal and a pad image binary coded signal are respectively obtained as illustrated in Figure 3D which is also a waveform diagram.

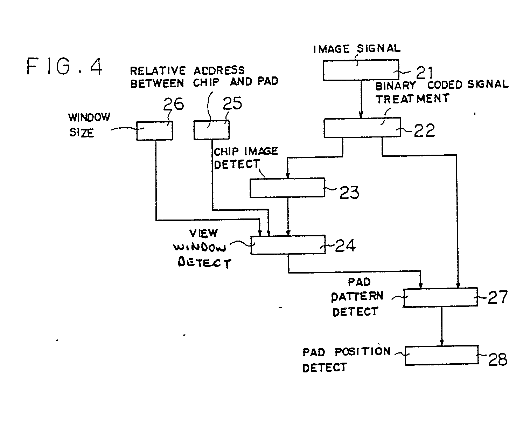

With reference to the schematic flowchart diagram of Figure 4, a description will be given of how an embodiment of this invention detects the position of a pattern.

In a step 22 in Figure 4, image signals generated at a step 21 by an image pickup 3 are converted into binary-coded signals having a desired threshold value. In step 23, the image of the IC chip 8 is detected. In step 24, chip image data showing the position and inclination of the IC chip 8, data supplied at step 25 and representing the positional relationship between the IC chip 8 and the pad patterns 9, and data supplied at step 26 and representing the size of a view window, are used to determine the position of a view window. The data supplied at steps 25 and 26 is all stored in a memory (not shown). In step 27, the binary-coded signals which represent a pad pattern 9 caught in the view window, and which have a threshold value different from that of the binary-coded signals used for representing the profile or outline of the IC chip 8, are used to obtain an image of the pad pattern 9. Finally, in step 28, the position of the pad pattern 9 is detected from the image obtained in step 27.

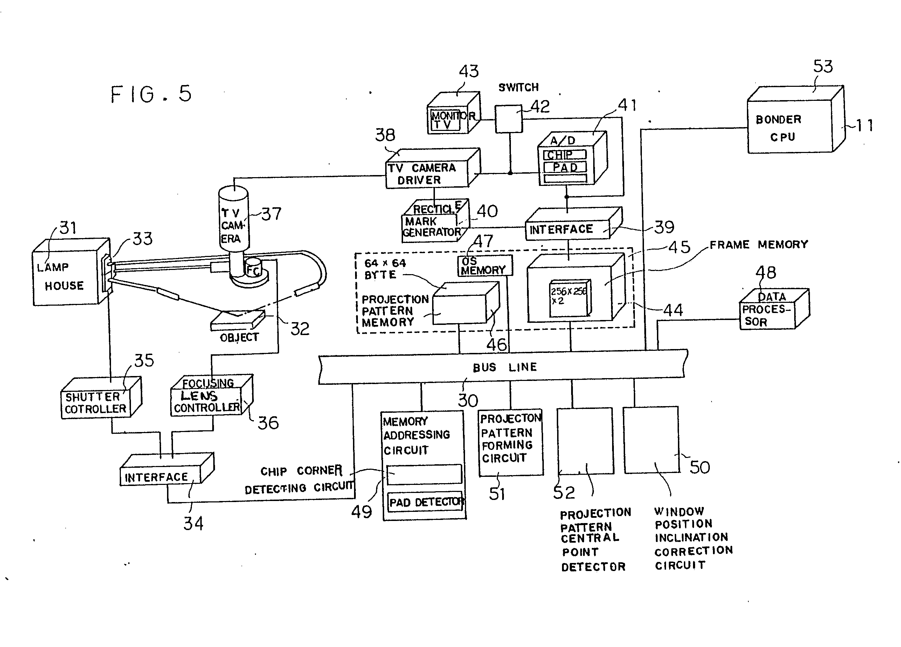

Figure 5 is a schematic synoptic block diagram of an apparatus embodying this invention.

In Figure 5, a lamp house 31 is a light source for emitting light to illuminate an object 32, i.e. a semiconductor IC chip. At an output side 33 of lamphouse 31, a shutter is provided. The shutter is opened and closed by a shutter controller 35, which is controlled by an interface 34. The interface 34 is connected to a bus line 30 and controlled by signals supplied via the bus line 30. The interface 34 is connected also to a focusing lens controller 36. Under the control of the interface 34 the controller 36 moves a focusing lens in front of a TV camera 37 back and forth, thereby adjusting the position of the focal point of the TV camera 37. The shutter controller 35 and the focusing lens controller 36 are signal adaptors which receive control signals from the interface 34 and which move the shutter and focusing lens, respectively, according to the control signal.

The lamphouse 31 applies light to the object 32. The TV camera 37 receives light reflected from the object 32 and converts the reflected light into electric image signals. The image signals are supplied to a TV camera driver 38. Connected to the TV camera driver 38 is a reticle mark generating circuit 40. The circuit 40 is connected to receive signals supplied from an interface 39 and generates a reticle mark signal. The reticle mark signal is supplied to the TV camera driver 38 upon receipt of the reticle mark signal, the TV camera driver 38 generates an output signal, which is supplied to an analog-digital converter 41. At the same time, the TV camera driver 38 transfers the image signals via a switching circuit 42 to a monitor TV set 43. The switching circuit 42 supplies image signals or binary coded signals to the monitor TV set 43, in accordance with the signals supplied from the interface 39.

The analog-digital converter 41 converts the image signals into digital signals, some for forming an image of the object 32 (e.g. a profile or outline image of the object), i.e. a semiconductor IC chip, and the others for forming an image of a pad pattern on the IC chip. All these digital signals are one-bit signals. However, the digital signals for forming an image of the IC chip have one threshold value and the digital signals for forming an image of a pad pattern have another threshold value. More precisely, the signals for forming an image of the IC chip have a threshold value such that a resultant image of the chip can clearly be distinguished from an image of an XY stage on which the IC chip is placed. The signals for forming an image of a pad pattern have a threshold value such that a resultant pad image can be clearly distinguished from the (general)IC chip image.

All the digital signals produced by the analog-digital converter 41 are stored in a frame memory 44 through the interface 39. An image formed by the digital signals, whether an IC chip image or a pad image, is formed of 256 (X-axis)×256 (Y-axis) bits. The frame memory 44 has a memory capacity corresponding to two images, i.e. an IC chip image and a pad image. That is, its memory capacity is (256×256)×2=131072 bits.

Besides the frame memory 44, there are provided a projection pattern memory 46 and an OS memory 47. The memories 44, 46 and 47 constitute a memory section 45. The projection pattern memory 46 is a 64×64 byte memory and the OS memory is a 4K byte memory storing operating software e.g. an operating system for general management of operations of the apparatus. To store the digital signals defining both the IC chip image and the pad image into the frame memory 44, a data processor 48 connected to the bus line 30 processes necessary data. A chip corner is detected by a chip corner detecting circuit 49 using image data (i.e. chip image data) stored in the frame memory 44 and representing a chip (e.g. an outline of the chip). Data relating to a window position is detected by using the chip corner detection data and data relating to inclination of the window position is dealt with (e.g. corrected for) by a circuit for correcting inclination of the window position. Thereafter, a projection pattern forming circuit 51 detects a projection pattern within the view window, namely, a projection pattern of a pad using data stored in the frame memory (pad image data) and corresponding to features found within the view window whose positon and inclination have been corrected. A circuit 52 for detecting a central point of the projection pattern detects a centre of the projection pattern, namely, a centre of the pad.

Such pad centre data as is detected above is used to control performance of a wire-bonding operation for the pad concerned. A wire is bonded to the pad concerned using the above-recited result under control of a bonder CPU 53.

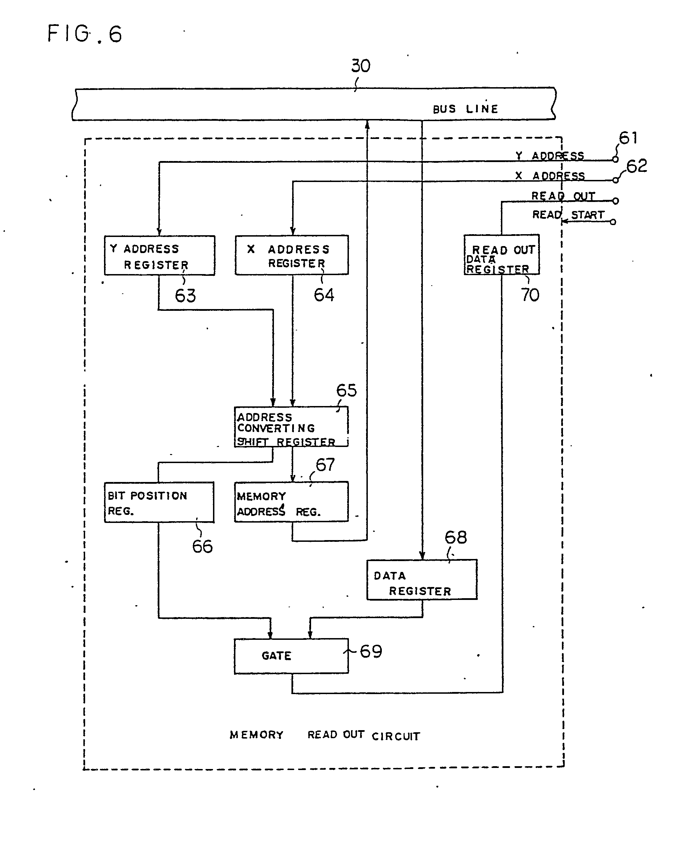

Figure 6 illustrates a memory reading circuit employed in the embodiment of the present invention shown in Figure 5. The data stored in the frame memory 44 comprises one-byte data, each byte consisting of eight picture elements. The memory reading circuit is so designed as to read one-bit data from the frame memory 44 which stores one-byte data. The circuit has a Y address input terminal 61 and an X address input terminal 62. When both address input terminals 61 and 62 receive address data (eight-bit Y address data and eight-bit X address data), the address data is stored in a Y address register 63 and an X address register 64, respectively. The address data is then transferred to an address converting shift register 65. The Y address data is stored in the upper memory location(s) of the shift register 65, whereas the X address data is stored in the lower memory location(s) of the shift register 65. The contents of the shift register 65 are shifted 3 bits at a time. Each three-bit data package delivered from the shift register 65 is written into a bit position register 66. The remaining thirteen bits in the shift register 65 are written into a memory address register 67 together with three-bit upper location address data (to make a sixteen bit address) allotted to a frame memory address.

The memory address register 67 may designate one of the addresses of the frame memory 44 through the bus line 30. If one address of the frame memory 44 is designated, one-byte data is read out of the address and then supplied to a data register 68. The eight-bit data is delivered to a gate circuit 69 when three-bit data is supplied to the gate circuit 69 from the bit position register 66. The gate circuit 69 delivers that one of the eight bits of the eight-bit data delivered thereto which is designated by the three-bit data supplied from the bit position register 66, and supplies this one-bit signal to a read-out data register 70. The register 70 therefore stores the one-bit data which is designated by the Y address data and X address data supplied through the address input terminals 61 and 62, respectively. Upon receipt of a READ-START signal the register 70 supplies the one-bit data.

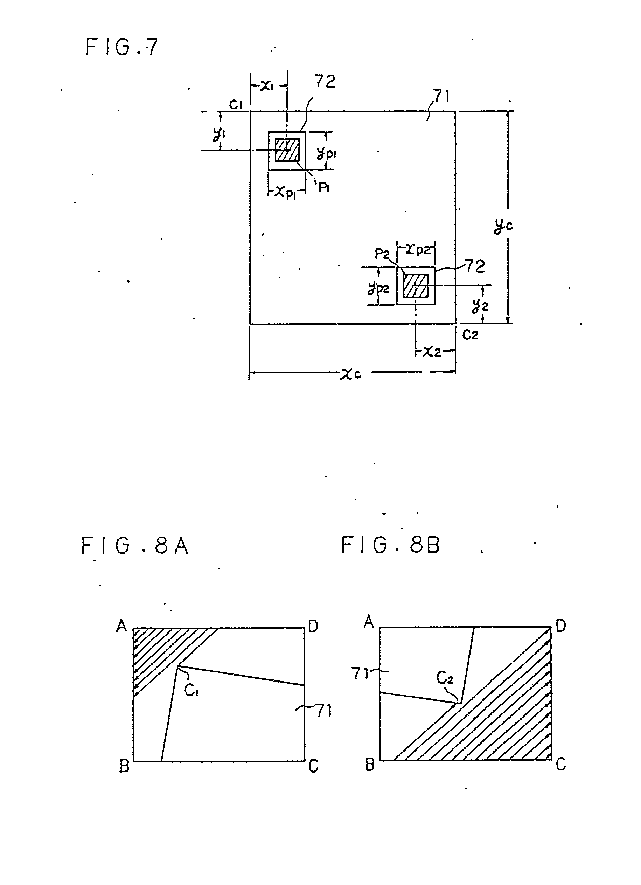

Figure 7 illustrates the positional relationship between an IC chip and pad patterns on the chip, and the size of a view window. Data showing the positional relationship and the view window size may be written into a memory (not shown) by known manual input means called "self-teaching I/O device". Some of this data may, for example, specify the distance $x_1$ between a corner $C_1$ of an IC chip image 71 and a vertical line passing through the centre of a pad pattern $P_1$, the distance $y_1$ between the corner $C_1$ and a horizontal line passing the centre of the pad $P_1$, the distance $x_2$ between another corner $C_2$ of the chip image and a vertical line passing the centre of a pad pattern $P_2$, and the distance $y_2$ between the corner $C_2$ and a horizontal line passing the centre of the pad pattern $P_2$. The centres of the pad patterns $P_1$ and $P_2$ each correspond to the centre of a view window 72. Other data may specify the lengths $x_{p1}$, $y_{p1}$, $x_{p2}$ and $y_{p2}$ of the four sides of the view window 72 and the lengths $x_c$ and $y_c$ of two adjacent sides of the rectangular IC chip image 71. The size of the view window 72 must be large enough to catch or encompass one pad pattern $P_1$ or $P_2$ even if the pad pattern happens to be inclined at about 10° or 15° in either direction (from alignment with the sides of the view window).

Now, with reference to Figures 8A and 8B, the detection of an IC chip image 71 will be described. More specifically, Figure 8A illustrates the detection of the upper-left corner $C_1$ of the IC chip image 71, and Figure 8B illustrates the detection of the lower-right corner $C_2$ of the IC chip image 71.

As shown in Figure 8A, an image area ABCD is scanned in a slant-wise direction, as indicated by arrows in the Figure, beginning at the upper-left corner A of the area ABCD. This scanning is performed in accordance with data written into memory by a self-teaching I/O device (not shown) and is continued until the upper-left corner $C_1$ of the IC chip image 71 is scanned. Thus, the first signal obtained by the scanning represents the upper-left corner $C_1$ of the IC chip image 71. Then, as shown in Figure 8B, another image area ABCD is scanned in slantwise direction, as indicated by arrows in the Figure, beginning at the lower-right corner C of the area ABCD. This scanning is performed until the lower-right corner $C_2$ of the IC chip image 71 is scanned. Thus, the first signal obtained by this scanning represents the lower-right corner $C_2$ of the IC chip image 71. Once both corners $C_1$ and $C_2$ have been thus detected, the position of the IC chip image 71 is detected.

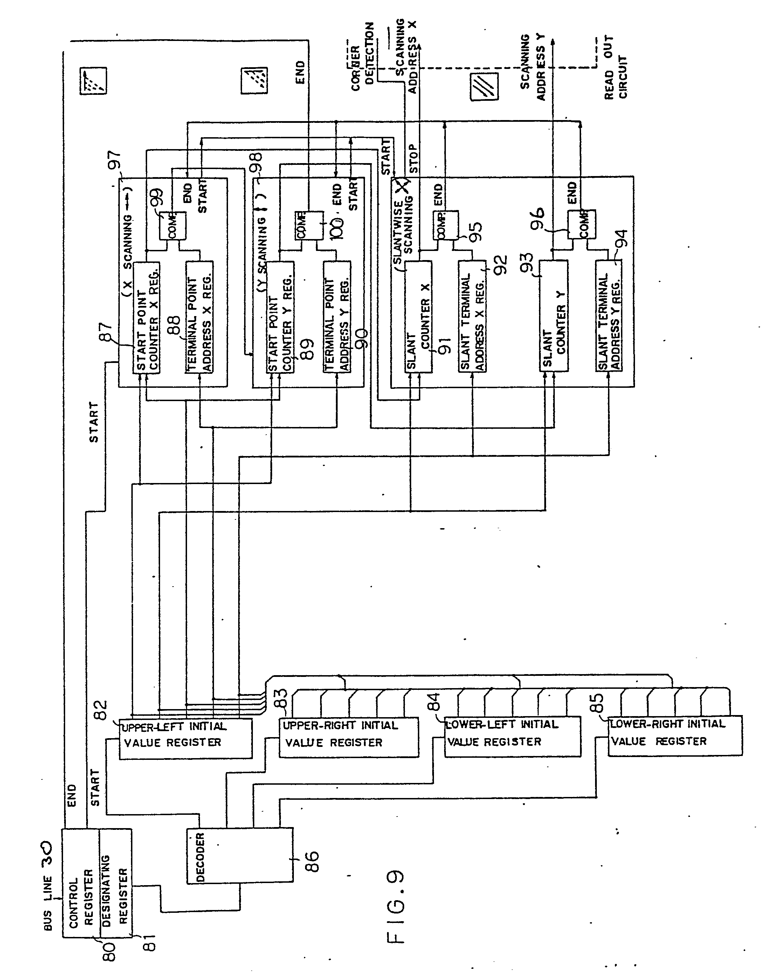

Figure 9 shows a chip-corner-detecting scanner circuit. Through the bus line 30 a signal representing one of four scanning directions, i.e. towards the upper-left corner, towards the upper-right corner, towards the lower-left corner, and towards the lower-right corner, is supplied to a scanning direction designating register 81. The register 81 is connected to a decoder 86. Through this decoder 86 the register 81 selects, according to the signal specifying scanning direction, one of four initial value registers, i.e. an upper-left initial value register 82, an upper-right initial value register 83, a lower-left initial value register 84 and a lower-right initial value register 85. The initial values from the register selected are stored into a start point counter X register 87, a terminal point address X register 88, a start point counter Y register 89, a terminal point address Y register 90, a slant counter X register 91, a slant terminal end address X register 92, a slant counter Y register 93, and a slant terminal address Y register 94. Data designating either count-up or count-down is supplied to the start point counter X register 87 and to start point counter Y register 89, and data designating count-up or count-down is supplied to the slant counter X register 91 and the slant counter Y register 93.

When a start signal is stored from the bus line 30 into a control register 80, the register 80 supplies a scanning start signal to the registers 87, 91 and 93. Upon receipt of the scanning start signal, the slant counter X register 91 and the slant counter Y register 93 start to increment or decrement. A comparator 95 compares the counts of the registers 91 and 92, and a comparator 96 compares the counts of the registers 93 and 94. When the counts of the registers 91 and 92 become equal, the comparator 95 supplies X scanning register group 97 and Y scanning register group 98 with a signal which shows that slant-wise scanning has been completed. Similarly, when the counts of the registers 93 and 94 become equal, the comparator 96 supplies the X scanning register group 97 and the Y scanning register group 98 with a signal which shows that slant-wise scanning has been completed.

Upon receipt of this signal from the comparator 96, the start point counter X register 87 is incremented or decremented and then feeds its contents to the slant counter X register 91. The contents of the start point counter Y register 89 remain unchanged and are supplied to the slant counter Y register 93. Supplied with new data, both registers 91 and 93 recommence slantwise scanning. They repeat slantwise scanning until the contents of the start point counter X register 87 become identical with those of the terminal point address X register 88. Whether or not the contents of the registers 87 and 88 are identical is detected by a comparator 99. When the contents of the registers 87 and 88 are found to be identical, the comparator 99 supplies a START signal to the Y scanning register group 98, keeping the contents of the register 87 unchanged.

Now, the start point in X-axis direction is fixed, and the contents of the start point counter Y register 89 are incremented or decremented every time slantwise scanning is effected. This slantwise scanning is repeated until the contents of the start point counter Y register 89 become identical with those of the terminal point address Y register 90. Whether or not the contents of the registers 89 and 90 are identical is determined by a comparator 100. When the comparator 100 detects identity, it supplies an END signal which indicates that slant wise scanning has been completed.

However, slantwise scanning is interrupted if a corner detection signal is supplied from a memory access circuit. That is, a corner detection signal stops the slantwise scanning. In practice, corner detection signals are supplied during the slantwise scanning, and the slantwise scanning is rarely completed.

In the chip corner detecting scanner circuit shown in Figure 9, X addresses are the contents of the slantcounter X register 91, and Y addresses are the contents of the slant counter Y register 93. The contents of these registers 91 and 93 are supplied as scanning addresses X and Y to a memory reading circuit as long as the slantwise scanning is carried out.

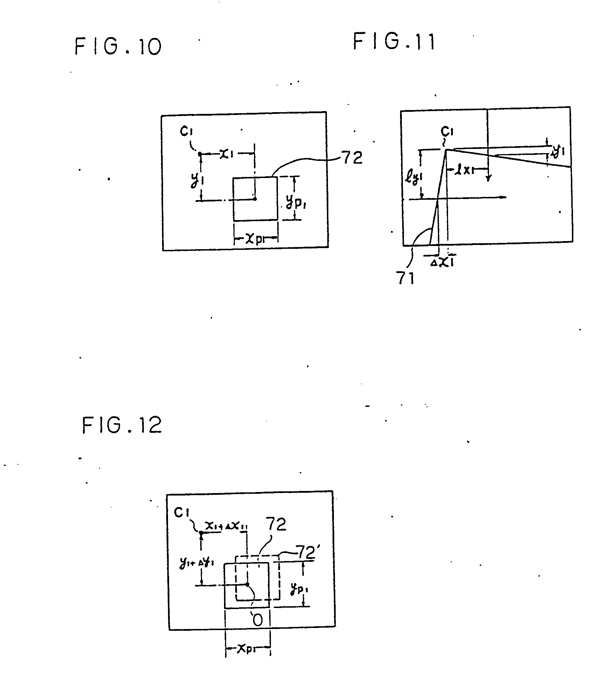

Now, with reference to Figures 10, 11 and 12, the determination of the size and position of a view window will be described.

First, as illustrated in Figure 10, the size and (uncorrected) position of a view window 72 is determined by data representing the distances $x_1$ and $y_1$ and the data representing the lengths $x_{p1}$ and $y_{p1}$– all this data having been read from memory. Then, the IC chip image 71 is scanned along a vertical line passing a point at horizontal distance $l_{x1}$ from the upper-left corner $C_1$ of the chip image 71, thereby detecting a displacement $\Delta y_1$ which depends on how much the IC chip image 71 is inclined. Further, the IC chip image 71 is scanned along a horizontal line passing a point at a vertical distance $l_{y1}$ from the upper-left corner $C_1$, thereby detecting a displacement $\Delta x_1$ which depends also on how much the IC chip image 71 is inclined. This done, using the displacements

$\Delta x_1$ and $\Delta y_1$ thus detected, the position of the view window 72 is corrected, as illustrated in Figure 12. This is, the view window 72, which was initially positioned as shown by broken lines at 72' in Figure 12, is so moved that its centre 0 is positioned at a horizontal distance $x_1+\Delta x_1$ from the upper-left corner $C_1$ of the IC chip image 71 and at a vertical distance $y_1+\Delta y_1$ from the upper-left corner $C_1$. The size of the view window 72 remains unchanged: two adjacent sides of the view window have respective lengths $x_{p1}$ and $y_{p1}$.

The view window 72 is not inclined, no matter how much the IC chip image 71 is inclined. A pad pattern is caught fully in the view window 72, nontheless. As mentioned above, the size of the view window 72 is large enough to catch or encompass one pad pattern, even if the pad pattern happens to be inclined at up to about 10° or 15° in either direction.

To place the view window 72 at such a position that a pad pattern near another corner of the IC image 71 may be caught in the view window 72, the position and size of the view window 72 are determined by data read out of the memory, using that other corner of the IC chip image 71 as a reference point.

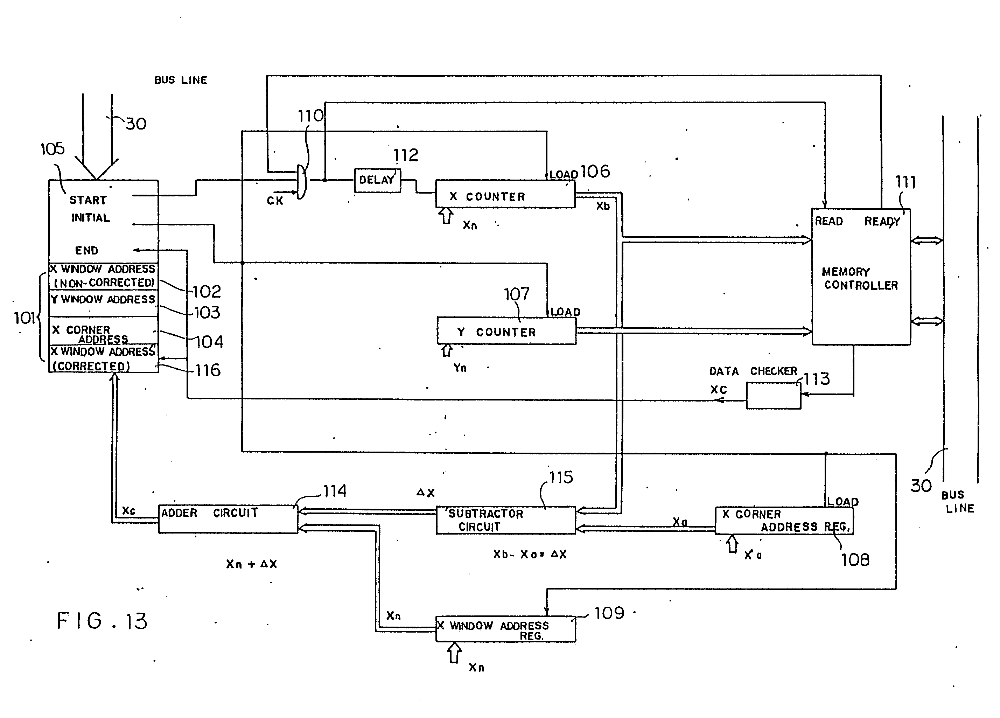

Figure 13 shows a circuit for correcting the position of the view window 72 (to take account of inclination of a pad pattern) in X direction, which is employed in the apparatus illustrated in Figure 5. The correcting circuit comprises a data register unit 101 which consists of an X window address (non-corrected) register 102, a Y window address (non-corrected) register 103, an X corner address register 104 and an X window address (corrected) register 116. Data is supplied from the bus line 30 to the registers 102 to 105. Then, control register 105 is initially set by an instruction applied also from the bus line 30. As a result, the contents Xn of the register 102 are transferred to an X counter 106 and an X window address register 109, the contents Yn of the register 103 are transferred to a Y counter 107, and the contents Ya of the register 104 are transferred to an X-corner address register 108.

Thereafter, a start instruction is supplied from the bus line 30 to the control register 105, the register 105 supplies a START signal to one input terminal of an AND gate 110. Another input terminal of the AND gate 110 is connected to a READY terminal of a memory controller 111. The memory controller 111 is in an initial state or in an "ON" state and thus generates a "1" signal. The "1" signal is supplied to the AND gate 110, whereby the AND gate 110 generates a clock signal. The clock signal is supplied via a delay circuit 112 to the X counter 106, thus incrementing the contents of the X counter 106. The clock signal is supplied also to a READ terminal of the memory controller 111. Upon receipt of the clock signal the memory controller 111 receives the contents of the X counter 106 and those of the Y counter 107. Further, the memory controller 111 reads from the frame memory 44 bit data from the address which has been designated by the contents of the X counter 106 and the contents of the Y counter 107. The bit data is supplied to a data checker 113, which detects whether the data is a "1" signal or a "0" signal. When the bit data is a "0" signal (e.g. indicating that a part of the chip has been detected at the corresponding location), the data checker generates an output signal $X_c$. The signal $X_c$ is supplied to the X window address (corrected) register 116 and also the control register 105 as an END signal. When the bit data is a "1" signal (e.g. indicating that no part of the chip has been detected), the data checker 113 generates no signal. At this the AND gate 110 supplies clock signals one after another, and the sequence of operations mentioned here is repeated until the data checker receives a "0" signal.

The correcting circuit further comprises a subtractor circuit 115 which subtracts the contents Xa of the X corner address register 104 from the contents Xb of the X counter 106, thus obtaining a difference $\Delta x (=Xb-Xa)$. The data showing the difference $\Delta x$ is supplied to an adder circuit 114, which adds the difference $\Delta x$ to the contents Xn of an X window address register 109. The sum $Xc(=Xn+\Delta x)$ is supplied to the X window address (corrected) register 116. The data showing the sum Xc, however, is not written into the register 116 until the signal Xc is supplied to the register 116 from the data checker 113. That is, the data showing the sum Xc is written into the register 116 when the data checker receives "0". Similar processing is carried out in the Y direction.

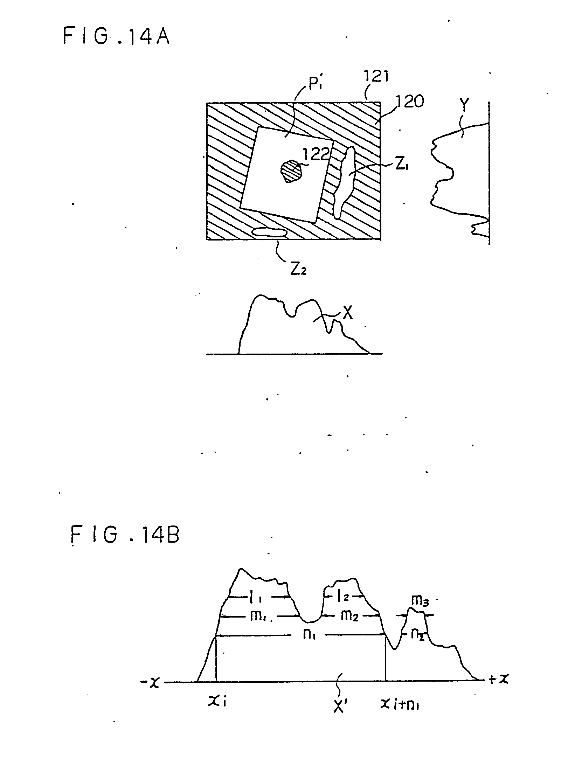

Now the determination of the position and size of a pad pattern image within the view window 72 will be described with reference to Figures 14A and 14B.

As shown in Figure 14A, a pad pattern image $P'_1$ obtained by converting image signals representing a pad pattern into binary coded signals is effectively projected onto both X and Y axes, thus obtaining an X-axis projection pattern X and a Y-axis projection pattern Y. In Figure 14A, 122 is a production probing (P—P) scar, $Z_1$ and $Z_2$ are patterns which need not be identified, 120 is a non-signal region, and 121 is a view window. The width and centre of the X-axis projection pattern X and the width and centre of the Y-axis projection pattern Y are determined in the following manner, thereby to determine the position and size of the pad pattern image $P'_1$.

The diagram of Fig. 14B represents in graphical form a X-axis projection pattern X'. This pattern comprises a succession of image representing data values corresponding to respective positions along axis $-X +X$ shown in the diagram. The values very along the axis as shown and correspond effectively to a projection of the image $P'_1$ onto the axis.

Figure 14B illustrates the determination of the width and centre of a X-axis projection pattern X'. First, numbers of consecutive image-representing data values whcih exceed a selected threshold value disposed in an upper portion of the projection pattern X', are counted, for example detecting two counts or lengths $l_1$ and $l_2$. If neither length is found to be longer than a predetermined pad pattern width $l_0$ already written into memory, numbers of consecutive values which exceed a lower threshold value, disposed in a portion of the pattern X' which lies below the said upper portion, are counted, thus detecting lengths $m_1$, $m_2$ and $m_3$ for example. The lengths $m_1$, $m_2$ and $m_3$ are compared with the predetermined pad pattern width $l_0$. If none of the lengths $m_1$, $m_2$ and $m_3$ is longer than $l_0$, numbers of consecutive values which exceed yet a lower threshold value are counted. Similar operations are repeated until a length (number of consecutive values exceeding a set threshold level) is found to be longer than the width Lo. For example, when a length $n_1$ is found to be longer than the width $l_0$, the length $n_1$ is regarded as the width of the X-axis projection pattern X'. The address $x_i$ of one end of the length is detected, and so is the address $x_i+n_1$ of the other end of the length. The address $(x_i+x_i+n_1)/2$ of the middle point of the length is regarded as the address of the centre of the X-axis projection pattern X'.

The width and centre of the Y-axis projection pattern Y are determined in the same way. According to the addresses of centres of X-axis and Y-axis projection patterns, the address of the centre of the pad pattern $P'_1$ is determined.

Alternatively, in order to determine the address of the centre of the pad pattern $P'_1$, first a threshold value disposed in the lowest portion of the pattern X', is selected and numbers of consecutive values of the pattern $P'_1$ exceeding that value are counted and then a higher threshold value or higher threshold values are selected and similar counts made, until a count is made which corresponds to a length shorter than the predetermined pad pattern width $l_0$. Then, the length (or counted number of consecutive values exceeding the threshold value) corresponding to the threshold value immediately below the threshold value to which the length shorter than $l_0$ applies is regarded as the width of the pad pattern. This method uses the same effect as the above-mentioned method.

The above mentioned method of determing the address of the centre of the pad pattern $P'_1$ is advantageous in some respects, whether a count is made (or a length detected) in relation to a highest threshold value first, or a lowest threshold value first. First, the correct width of the pad pattern $P'_1$ can be detected even if the pad has a P—P scar. Secondly, patterns which need not be identified, such as wire patterns, are not detected, if any.

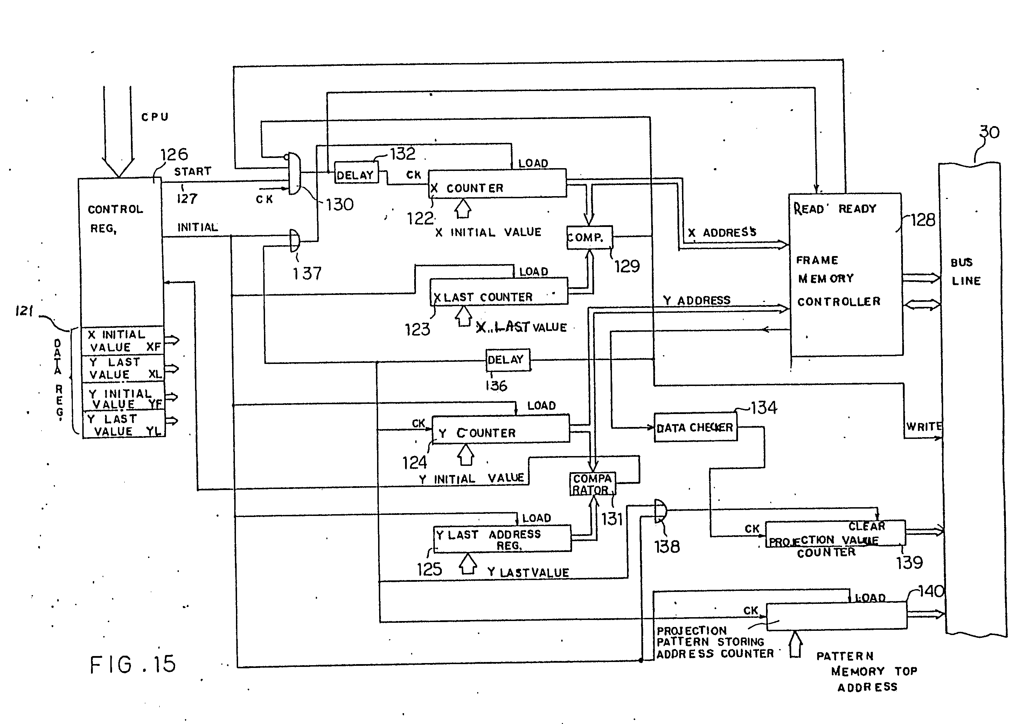

Figure 15 shows a projection pattern forming circuit as employed in the apparatus shown in Figure 5. An initial X value XF, a last X value XL, an initial Y value YF and a last Y value YL supplied through the bus line 30 are written into a data register 121. These values XF, XL, YF and YL are written respectively into an X counter 122, and X last address register 123, a Y counter 124 and a Y last address register 125 when a initial instruction is fed to a control register 126. Further provided is a projection pattern storage address counter 140, into which the first address data of the projection pattern memory 46 (see Figure 5) is written.

When an initial instruction is fed to the control register 126, the data register 121 supplies a start signal through its start signal output terminal 127. If an initial stage operation or a last stage operation has been completed, a READY signal from the frame memory controller has "1" level and the output of a comparator 129 has "0" level. In this case, an AND gate 130 generates a clock signal when it receives the start signal from the data register 121. The output of the AND gate 130 i.e. the clock signal, is supplied through a delay circuit 132 to the X counter 122 and thus increments the count of the X counter 122. At the same time, the output of the AND gate 130 is supplied to the read terminal of the frame memory controller 128, through which X address data and Y address data are written into the frame memory controller 128.

When the clock signal is supplied to its READ terminal, the frame memory controller 128 starts storing data from the X counter 122 and the Y counter 124. The controller 128 supplies a data checker 134 with two-bit dot data from the frame memory 44 and which corresponds to the (address) data from the X counter 122 and the Y counter 124, i.e. the X address data and the Y address data of the frame memory 44. When it receives "1" data from the controller 128, the data checker 134 increments the count of a projection value counter 139. This sequence of operations is repeated until the data stored in the X counter 122 becomes identical with the data stored in the X last address register 123. That is, the operation is repeated until the data checker 134 finishes checking all the two-bit dot data that constitutes one row of the frame memory 44.

When the data stored in the X counter 122 and the X last address register 123 are found to be identical, the comparator 129 generates a "1" signal. This "1" signal is supplied to the AND gate 130 and opens the same. The AND gate 130 no longer generates a clock signal. Thus, the count of the projection value counter 139 is stored into the projection pattern memory 46. The output of the comparator 129 is supplied via a delay circuit 136 to the Y counter 124 and a projection pattern storage address counter 140. Hence, the output of the comparator 129 increments both the Y counter 124 and the counter 140. Further, the first X value XF is loaded (into 122) through the delay circuit 136 and an OR gate 137 according to the output of the comparator 129. Still further, the output of the comparator 129 is supplied through an OR gate 138 to the projection value counter 139 and clears the count of the counter 139.

When the count of the X counter 122 becomes equal to the first X value FS in the above mentioned manner, the output of the comparator 129 again comes to have a logic level "0", thus turning "ON" the AND gate 130. Once the AND gate 130 is turned "ON", the number of bits constituting a row are counted. This is continued until the count of the Y counter 124 becomes equal to the data stored in the Y last address register 125. When the count of the Y counter 124 becomes equal to the data stored in the Y last address register 125, a comparator 131 generates an output of "1" level. The output of the comparator 131 is subjected to an END terminal of the control register 126, indicating that the projection pattern has been formed completely. Then, data representing a pad image projecting in the Y axis direction is stored into the projection pattern memory 46 through the bus 30.

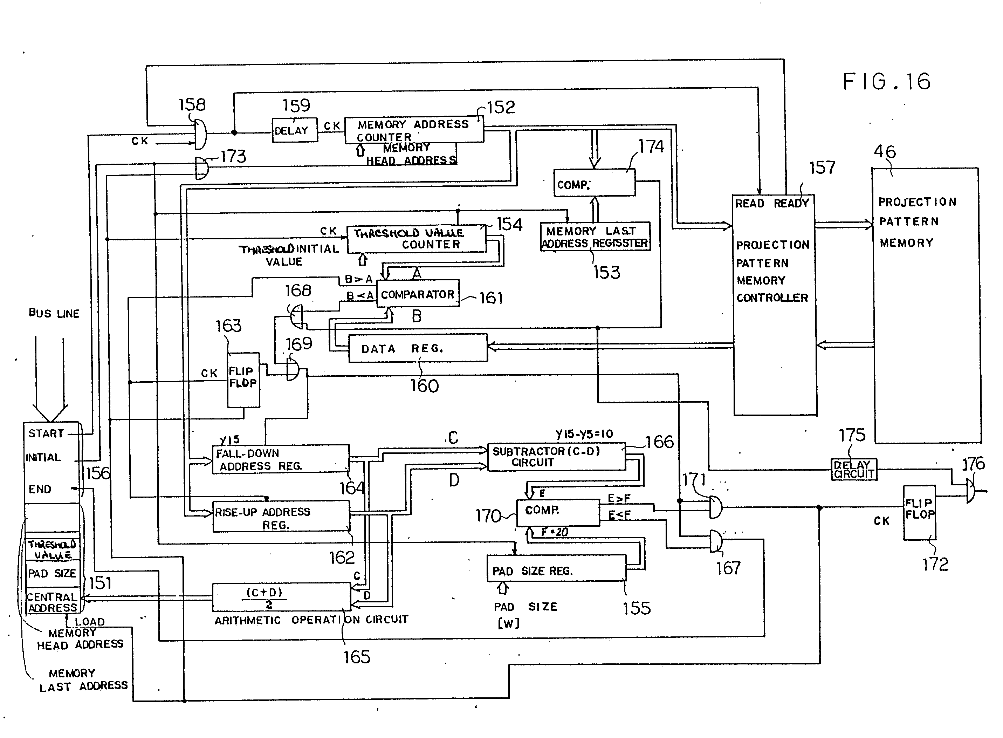

Figure 16 illustrates a circuit for detecting a middle point of a projection pattern, as used in the apparatus as shown in Figure 5. The circuit is provided with a data register 151. The data register 151 is connected to the bus line 30 to receive memory heading address initial data, memory last address data, slice level initial data, and pad size data. All this data is loaded, according to initial set instructions supplied to the CPU, into a memory address counter 152, a memory last address counter register 153, a threshold value counter 154 and a pad size register 155, respectively. When a start instruction is supplied from the CPU to a register 156, the register 156 generates a start signal. The start signal is supplied to an AND gate 158.

A READY signal supplied from a projection pattern memory controller 157 has a "1" level at first. The READY signal is supplied to the AND gate 158, and, upon receipt of a clock signal, the AND gate 158 is closed, thus generating an output signal. The output signal of the AND gate 158 i.e. the clock signal, is supplied via a delay circuit 159 to the memory address counter 152. The memory address counter 152 is incremented every time it receives a clock signal from the AND gate 158. The output signal of the AND gate 158 is at the same time supplied to a READ terminal of the projection pattern memory controller 157. Through the READ terminal the count of the memory address controller 152 is read into the projection pattern memory controller 157. When the output of the AND gate 158 i.e. a clock signal, is supplied to the READ terminal, the projection pattern memory controller 157 receives the count of the memory address controller 152 and reads the data from that address of the projection pattern memory 46 which has been designated by the count of the memory address counter 152. The data read from the projection pattern memory 46 is stored into a data register 160 through the projection pattern memory controller.

The circuit of Figure 16 further comprises a comparator 161. The comparator 161 is connected to the data register 160 and receives the data therefrom. The comparator 161 compares the data stored in the data register 160 with the data initially stored in the threshold value counter 154. It keeps on comparing these data until the data stored in the data register 160 becomes the larger. That is, data is read out of the

projection pattern memory 46 sequentially from addresses sequentially designated by the memory address counter 152. When the data stored in the register 160 becomes larger than the data initially stored in the threshold value counter 154 the contents of the memory address counter 152 are supplied to a rise-up register 162 through the comparator 161. Once the contents of the counter 152 have been stored into the rise-up register 162, a flip-flop 163 generates a "1" level signal.

The memory address counter 152 is further incremented gradually as clock signals are supplied to the AND circuit 158. Thus, data is read from the data register 160 until the comparator 161 detects that the contents of the data register 160 have become smaller than the contents of the threshold value counter 154. When the contents of the data register 160 are found to be smaller than those of the threshold value counter 154, the comparator 161 supplies a fall down address register 164 with a signal through an OR gate 168 and an AND gate 169. This signal instructs the fall-down address register 164 to store the contents of the memory address counter 152. Once the contents of the memory address counter 152 have been stored into the fall-down address register 164, an arithmetic operation circuit 165 calculates $(C+D)/2$, where C is the contents of the fall-down address register 164 and D is the contents of the rise-up address register 162.

The circuit of Figure 16 further comprises a subtraction circuit 166 and a comparator 170. The subtraction circuit 166 calculates the difference between data C (i.e. the contents of the fall-down address register 164) and data D (i.e. the contents of the rise-up register 162)—that is: $E=C-D$. The comparator 170 compares data E with data F which is stored in the pad size register 155 and which represents the size of a pad. If E is larger than F, and AND gate 171 generates an output signal, which sets a flip-flop 172. Further, if E is larger than F, the output of the arithmetic operation circuit 165, i.e. $(C+D)/2$ is stored into the middle point (central) address register of the data register 151, the flip-flop 163 is reset, a heading address data is supplied to the memory address counter 152 via an OR gate 173, and a signal is applied to the threshold value counter 154 to increment the same. Sequence of operations is repeated until E becomes smaller than F.

When E becomes smaller than F, an END signal is fed to the register 156 through an AND gate 167. The END signal terminates the detection of the middle point. The middle point address register therefore stores the data with which it is supplied immediately before E becomes smaller than F.

The circuit of Figure 16 is further provided with another comparator 174. The comparator 174 continuously compares the data stored in the memory last address register 153 and the count of the memory address counter 152. When the count of the memory address counter 152 becomes greater than the data stored in the memory last address register 153, the comparator 174 delivers an error signal through a delay circuit 175 and an AND gate 176.

To detect the position of the IC chip image 71, various apparatuses other than as above described may be used according to the present invention. For example, a rectangle circumscribed by the IC chip image 71 may be used to detect the position of the chip image 71, as disclosed in Japanse Patent Application No. 55-28597, filed by the inventors of the present invention.

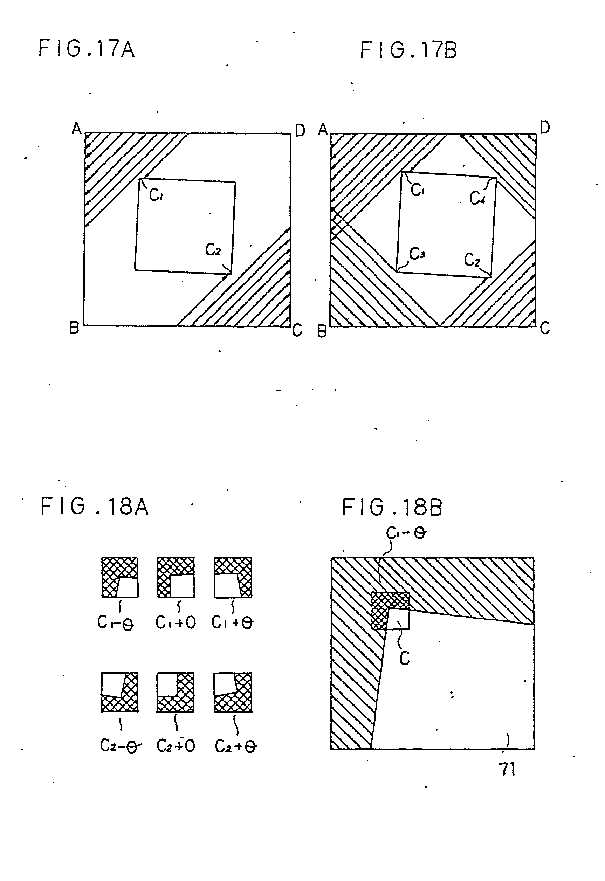

Further, as shown in Figure 17A, an image area ABCD may be scanned slantwise, beginning at the upper-left corner A and lower right corner C of the area ABCD. In this case, scanning is continued until the corners $C_1$ and $C_2$ of the IC chip image 72 are detected.

Still further, as illustrated in Figure 17B, an image area ABCD may be scanned slantwise, beginning at the four corners A, B, C and D, and scanning continued until the corners $C_1$, $C_2$, $C_3$ and $C_4$ of the IC chip image 72 are detected.

Furthermore, use may be made of templet data $C_{1-\theta}$, $C_{1+0}$, $C_{1+\theta}$ and $C_{2-\theta}$, $C_{2+0}$, $C_{2+\theta}$, as shown in Figure 18A. A memory storing a chip image data image 71 as shown in Figure 18B is scanned, and templet data, $C_{1-\theta}$ for example, is subjected to pattern matching with the desired corner $C_1$ of the chip image, thereby to detect a corner of the IC chip image 71. Each templet may be used to seek a match. The templet data provides templet patterns with which the desired corner of the chip image is compared.

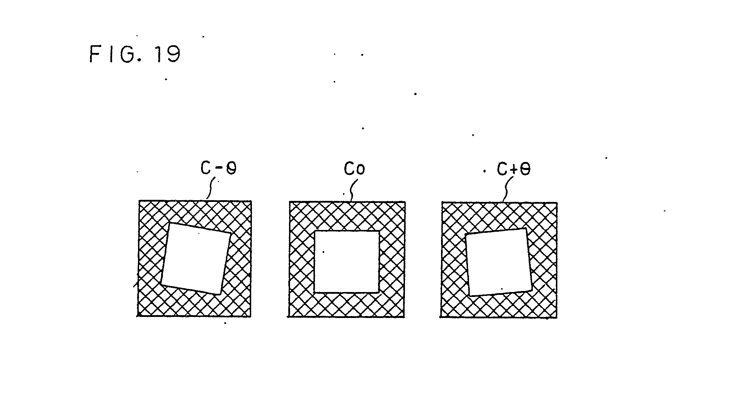

Still further, use may be made of templet data $C-\theta$ CO and $C+\theta$ such as is shown in Figure 19. These templets surround the four sides of the chip image, and define chip images inclined at angles $-\theta$, 0 and $+\theta$, respectively. The templet data is subjected to pattern matching with the chip image, thereby to detect the position of the IC chip image 71. The methods using such templet data as shown in Figures 18A and 19 require a pattern matching circuit.

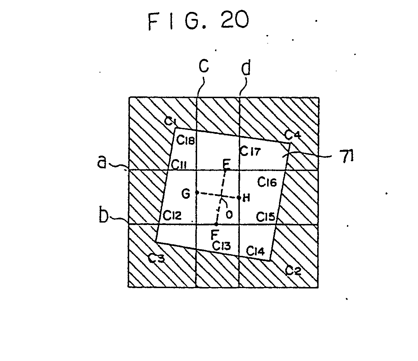

To detect both the position and inclination of the IC chip image 71, a method as illustrated in Figure 20 may be emmployed. That is, a chip image 71 is scanned along two parallel lines a and b and then along two parallel lines c and d. Then, addresses C11 and C18 of points where the four sides of the image 71 intersect with the lines a to d are detected. Middle point E, F, G and H of $\overline{C11\,C16}$, $\overline{C12\,C15}$, $\overline{C13\,C18}$ and $\overline{C14\,C17}$ are calculated. From the addresses of the middle points E, F, G and H, the address of the centre O of the chip image 71 is obtained. Further, the inclination of the image 71 is calculated, and the addresses of corners $C_1$, $C_2$, $C_3$ and $C_4$ of the chip image 71 are detected.

The inclination of the chip image 71 may be detected by other methods. For instance, either of the methods shown in Figure 10 and Figure 11 of Japanese patent Application No. 55-28597 may be employed.

If the above described methods are employed to identify a pad pattern the profile of the IC chip need not be detected with such high precision as is required to determine the correct centre of the pad pattern. Thus, the size of one-bit data (e.g. the size of a picture element represented by one-bit data) used for detecting the profile of the IC chip may be larger than that of one-bit data used for identifying a pad pattern. If the sizes of one-bit data are made different in this way and thus the resolutions of the chip image and pad pattern image are made different, the efficiency of pad pattern identification will be enhanced.

In the above described embodiments of the present invention, use is made of only one view window. Alternatively, the position and size of another, smaller, view window may be determined in the same way as described above for one view window. Furthermore, a third smaller view window may also be used, position and size being determined similarly.

As mentioned above, according to the above described embodiments of the present invention, the profile or outline of an object is first detected through simple data processing the size and position of a view window are than determined, the position of the view window is corrected if necessary so that a pattern on the object may be caught in the view window. Once the pattern is caught in the view window, its position can be detected by processing a small amount of data. It follows that the pattern can be identified at higher speed and patterns near to the pattern to be identified, if any, are never identified. Thus, a method employed in embodiments of this invention can identify a pattern both quickly and accurately.

The above explanation has been given in relation to embodiments of the present invention in which a single optical lens has been employed. Other embodiments of the present invention will be described hereinafter, in which two optical lens systems are used.

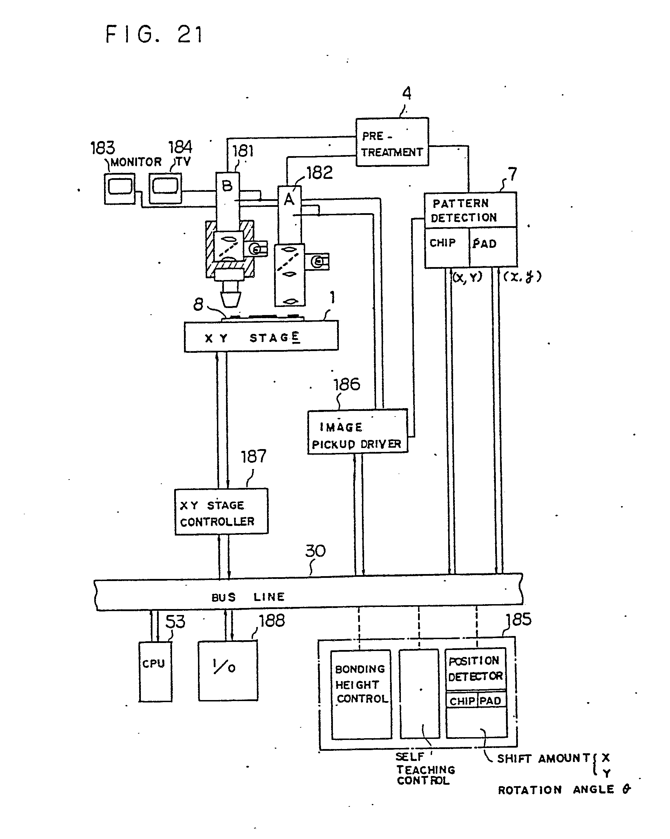

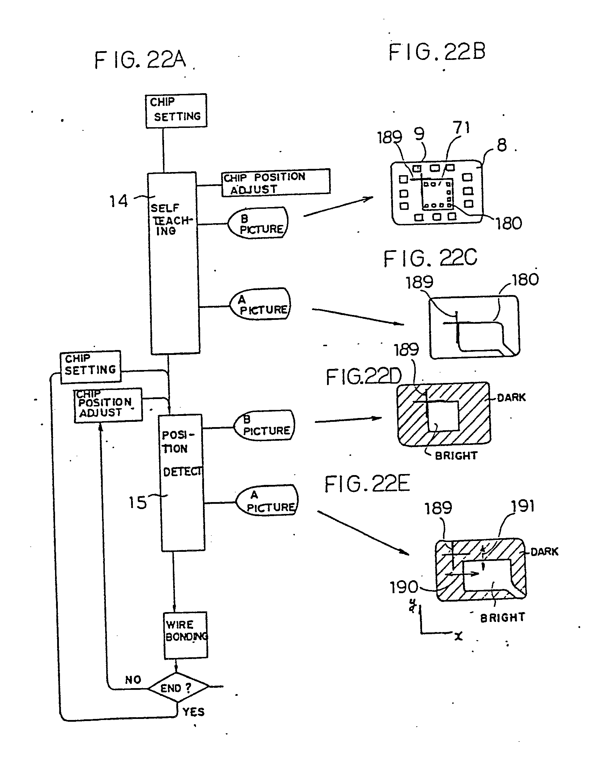

As shown in Figure 21, a hybrid IC having one IC chip pellet 8 is placed on an XY stage 1. The IC chip pellet 8 has an IC chip pattern 71 and a first IC pad pattern 9 as shown in Figure 22B. On the IC chip pattern 71 a second IC pad pattern 180 is laid as illustrated also in Figure 22B. The IC chip pattern 71 is photographed or imaged by two optical systems provided in parallel to one another i.e. a B optical system 181 and an A optical system 182. The B optical system 181 catches within its view field the IC chip pellet 8 having the IC chip pattern 71 and receives images data pertaining to the IC chip pattern 71. The A optical system 182 catches within its view field only the second IC pad pattern 180 and receives image data pertaining to the IC pad pattern 180. The optical systems 181 and 182 cooperate to detect the positions of bonding pads.

Suppose the maximum size of the IC chip the position of which may be detected by the B optical system 181 is 2 mm×2 mm and that the IC chip may be displaced ±0.2 mm from a prescribed position on the XY stage 1. Then, the B optical system 181 and the A optical system 182 have view field sizes and image resolutions as shown in Table 1.

TABLE 1

|  | View field | Resolution | Remarks |
|---|---|---|---|
| B Optical system | 2.56 mm×2.56 mm | 10 μm | Chip size:<br>2 mm×2 mm |
| A Optical system | 0.256 mm×0.256 mm | 1 μm | Chip positioning<br>Accuracy: ±0.2 mm<br>Pad size: 0.15 mm²<br>Picture element:<br>256×256 |

As Table 1 shows, the position of the IC chip pellet 8 can be detected to within 10 μm by the B optical system 181. Since the displacement of the IC chip pattern 71 and any other pattern laid on the pellet 8 is limited to within ±20 μm, it is possible to estimate the position of the bonding pads laid on the IC chip pattern to an accuracy of ±30 μm.

Using the value thus estimated, the second pad pattern 180 is aligned with the A optical system 182. Then, the second pad pattern 180 is placed within the view field of the A optical system which has a size 0.256 mm×0.256 mm, whereby the positions of individual bonding pads can be detected with a resolution of 1 μm.

Output data from the optical systems 181 and 182 is displayed by monitor television sets 183 and 184. Simultaneously, output data from 181 and 182 is supplied to a binary-coded signal processing circuit 4 and converted into binary-coded signals having two threshold values, which may be respectively adopted by the output signals from the two optical systems 181 and 182. The binary-coded signals are supplied to a pattern detecting section 7. The pattern detecting section 7 generates data representing the position (i.e. X—Y coordinates) of the IC chip pellet 8 according to the data supplied from the B optical system 181. It also generates data representing the position (i.e. X—Y coordinates) of a bonding pad according to data supplied from the A optical system 182. The output data of the pattern detecting section 7 is supplied to a bus 30.

Connected to the bus 30 is a memory 185 storing a self-teaching algorithm and a position detecting algorithm. When the output data of the section 7 is supplied to the bus 30, the corresponding data is read from the memory 185 and supplied to an image pickup section driver 186 under the control of a program instruction supplied to the bus 30 from a central processing unit (CPU) 53. In response to the data read from the memory 185, the driver 186 drives both optical systems 181 and 182. In the meantime, an algorithm for sequence drive of the XY stage 1 is read out of the memory 185 and supplied to an XY stage controller 187. At the same time, a program instruction is supplied to the controller 187 from the CPU 53. According to the sequence drive algorithm and under the control of the program instruction, the XY stage controller 187 moves the XY stage 1, thereby aligning the IC chip pellet 8 with a wire bonding apparatus (not shown). Connected also to the bus 30 are various input—output (I/O) devices 188. Through the bus 30 the I/O devices 188 can supply and receive various data.

The detail circuit of the pattern detecting section 7 and the circuits by which operations are effective in relation to data stored in the memory 185 have been explained above.

Figure 22A is a flow chart illustrating how the image pickup section of the apparatus shown in Figure 21 detects the position of a pattern. Figures 22B, 22C, 22D and 22E show images displayed by the monitor television sets 183 and 184.

The image pickup section detects the position of the pad pattern 180 in two stages, i.e. a self-teaching step for manual rough alignment of the pad pattern and a position detecting step for automatic fine alignment of the pad pattern.

In the first step, the IC chip pellet 8 shown in Figure 22B is placed on the XY stage 1. Then, the XY stage 1 is moved by hand so that the B optical system 181 catches in its view field the IC chip pattern 71. the IC chip pattern 71 or image B is displayed by the monitor television set 183. Seeing the image B, an operator places a reticle mark 189 at a desired position of the IC chip pattern 71, as illustrated in Figure 22B, by his own hand. This done, the A optical system 182 is operated, thereby displaying the IC pad pattern 180 or image A on the monitor television set 184. Seeing the image A thus displayed, the operator places with his hand another marker (reticle mark) 189 at a desired position of the IC pad pattern, as illustrated in Figure 22C. Thus, the detection windows of both optical systems 181 and 182 are set, these windows being displayed as bright portions on the monitor television sets 183 and 184.

The second step, i.e. automatic fine alignment of the pad pattern is then commenced. First, another IC chip pellet is placed on the XY stage 1, after removing the IC chip pellet 8 therefrom. The optical systems 181 and 182 are operated, thereby displaying the IC chip pattern and IC pad pattern of the new pellet on monitor television sets 183 and 184. If the IC chip pattern is found to align with image B as shown in Figire 22D and the IC pad pattern is found to be displaced from image A as shown in image 22E, the image pickup section driver 186 and the XY stage controller 187 are driven according to data indicative of the displacement of the pad pattern from the reticle 189 in terms of X—Y coordinates 190 and 191, whereby the bonding pads are positioned exactly in alignment with the wire bonding apparatus (not shown). Thereafter, the height of the bonding pads is detected. Finally, automatic wire bonding apparatus is operated, thus performing wire bonding on the IC chip pellet.

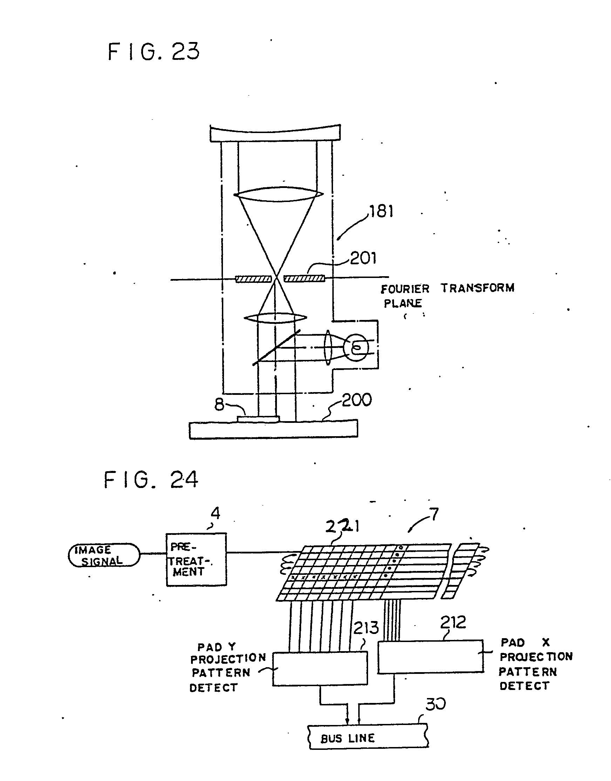

Figure 23 shows another embodiment of the present invention, which can offer an improved optical S/N ratio for an image picked up by a B optical system. This apparatus is identical with that of Figure 21, except that use is made of a substrate 200 having a rough surface and that the B optical system is provided with a filter for removing optical high spatial frequency components from incident light. The filter may be a low-pass filter such as is generally employed, as disclosed in "Handbook of Optical Technology", Asakura Book Co., Japan to lessen the granularity of an image. Alternatively, the filter may be a diaphragm 201 which is placed in the Fourier transform plane of the image as shown in Figure 23 thereby to shield the high frequency components of incident light. As a result, the B optical system 181 generates image signals of a large S/N ratio.

Figure 24 illustrates another embodiment of the present invention, which can provide improved operational efficiency for a pattern detecting section 7 such as is shown in Figure 21. As shown in Figure 24, image signals are converted by a pre-treatment circuit 4 into binary-coded signals. The binary-coded signals are supplied to a two-dimensional shift register 211. The memory bits of the register 211 are scanned in X direction by a circuit 212 for detecting a projection pattern in a X direction and in Y direction by a circuit 213 for detecting a projection pattern in a Y direction, whereby the four corners of each bonding pad 180 (Figure 22B) may be detected. In practice, only two pads, one positioned at the upper-left corner of such an IC chip pattern 71 as shown in Figure 22B and the other positioned at the lower-right corner of the IC chip pattern 71 are detected, thereby to determine the positions of all the bonding pads. This is an effective method of detecting a pad pattern.

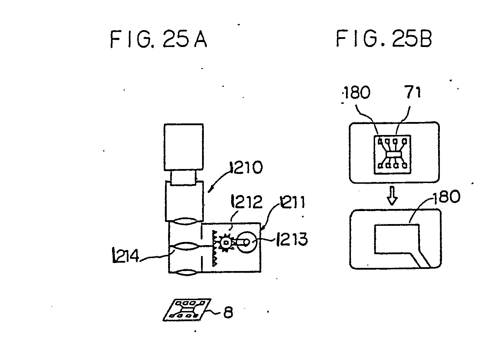

Figures 25A and 25B, Figures 26A and 26B, and Figures 27A and 27B illustrate three further embodiments of the present invention, wherein the two optical systems 181 and 182 shown in Figure 21 are replaced by one image pickup device which sequentially picks up an IC chip pattern and an IC pad pattern or which picks up both an IC chip pattern and an IC pad pattern at the same time by either electrical or optical means, thus achieving the same effect as provided by the embodiment shown in Figure 22.

In the embodiment of Figures 25A and 25B, an image pickup device 1210 is provided with automatic zooming lens unit 1211. The unit 1211 comprises a gear mechanism 1212, a motor 1213 and a lens systems 1214. The motor 1213 drives the gear mechanism 1212 which in turn drives the lens system 1214. The unit 1211 is automatically operated so as to pickup such images as are shown in Figure 25B, which are similar to the images shown in Figure 22B and 22C, or Figures 22D and 22E.

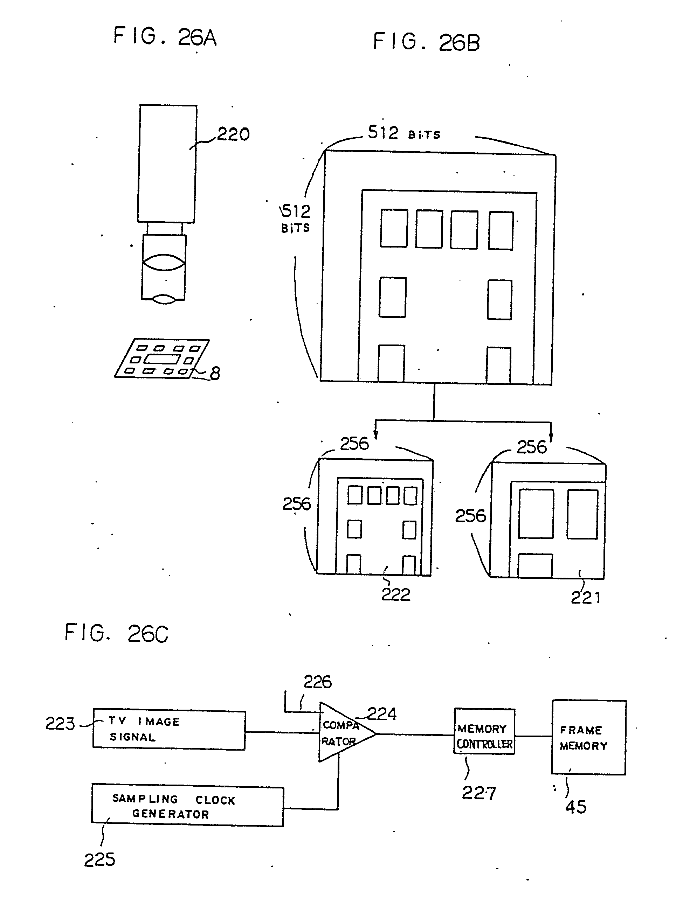

In the embodiment of Figures 26A and 26B, an image pickup device 220 is so designed as to change magnifying power electrically. Thus, it is possible to display an image 221 of a large magnifying power and an image 222 of a small magnifying power, as illustrated in Figure 26B. Figure 26C shows a circuit diagram of circuitry for electrically obtaining video image data corresponding to a large magnifying power and corresponding to a small magnifying power, using a single image pickup device. A TV image signal 223 or the output from the pickup device 220 is subject to a sampling operation at a comparator 224 when a sampling clock is supplied to the comparator 224 from a sampling clock generator 225. A threshold value voltage is fed to an input terminal 226 of the comparator 224. Sampling for a small magnifying power can be effected by making the sampling interval large and sampling for a large magnifying power can be performed by making the sampling interval small. In the embodiment shown in Figures 26A and 26B, for example, the TV image signal may be sampled at intervals of 10 μm—an image 222 of small magnifying power is derived with a sampling interval of 20 μm and image 221 of large magnifying power is derived at a sampling interval of 10 μm. The output of the comparator 224 is stored in the frame memory through a memory controller 227.

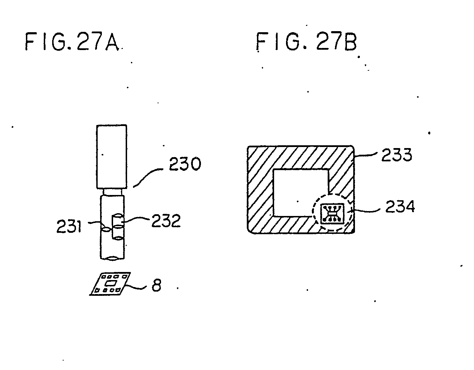

In the embodiments of Figures 27A and 27B, an image pickup device 230 is provided with two lens systems, i.e. a lens system 231 and a lens system 232. Thus, it is possible to display on the same display device an image 233 of a large magnifying power and an image 234 of a small magnifying power, as illustrated in Figure 27B.

As mentioned above, one apparatus embodying this invention is provided with a first optical system for picking up the IC chip pattern of a hybrid IC or the like a second optical system for picking up a pad pattern included in the IC chip pattern, using a substrate having a rough surface on which an IC chip pellet is placed, and employs a diaphragm in the Fourier transform plane of the first optical system, thereby displaying clear images of both chip pattern and pad pattern and detecting the correct positions of individual bonding pads. Hence the apparatus can facilitate a practically flawless wire bonding between the first pad pattern on the IC chip pellet and the second pad pattern on the IC chip pattern.

It should be noted that one picture element may correspond to two bits in the frame memory to express both chip and pad image based on the two threshold values of the binary coded signals.

As described above in detail, an embodiment of the present invention utilises two threshold values for an image signal picked up by the image pickup device and converted into binary coded signals, with a first threshold value corresponding to (used for detecting) the chip pattern and with a second threshold value corresponding to (used for detecting) the pad pattern. Thus, as both the chip and the pad patterns are formed on a frame memory as a binary image the position of a particular pad can be identified on the basis of the corner address of the chip with a high accuracy and with a high speed without processing data relating to the entire surface of the chips.

An embodiment of the present invention provides recognition apparatus comprising an image pickup section for picking up an image of a pad pattern laid on a IC chip pattern, a pre-treatment circuit for converting the outputs of the image pickup section into binary-coded signals in respect of at least two threshold values and a pattern detecting section for detecting the position and inclination of the pad pattern based on the images of the pad and chip patterns which are produced in a data memory by said binary-coded signals in accordance with said two threshold values respectively. Two image pickup devices may be used for picking up chip and pad data respectively.

## Claims

1. Position recognition apparatus, comprising an image pickup section (3) for imaging an object (8) and a pattern (9) on the object;

characterised in that the apparatus comprises means (4) for converting image signals output from the image pickup section (3) and corresponding to a predetermined field of view into first binary coded signals corresponding to image signals exceeding a first threshold value appropriate for distinguishing the object (8),

means (5) for detecting the absolute position and inclination of the object (8) on the basis of the first binary-coded signals;

means (6) for converting image signals, output for the image pickup section (3), corresponding only to a view window smaller than and within the predetermined field of view, into second binary coded signals corresponding to image signals exceeding a second threshold value, appropriate for distinguishing the pattern (9), and

means (7) for detecting the absolute position of the pattern (9) on the basis of the second binary-coded signals.

2. Apparatus as claimed in claim 1, further comprising means (6) for calculating the position of the view window from data representing the absolute position and inclination of the object (8) and data representing the relative position of the pattern (9) with respect to the object.

3. Apparatus as claimed in claim 1 or 2, wherein the position of the object (8) is detected at a relatively lower resolution and the position of the pattern (9) is detected at a relatively higher resolution.

4. Apparatus as claimed in claim 1, 2 or 3, operable to scan an image (71) of the object (8) slantwise, beginning at one corner of a rectangular image area (ABCD), thereby to detect the address of a corner of the object (Figs. 8A, 8B, 9).

5. Apparatus according to claim 1, 2, 3 or 4, operable to scan an image (71) of the object (8) along a vertical line passing through a point at a predetermined horizontal distance from one corner of the image (71) of the object (8) and/or along a horizontal line passing through a point at a predetermined vertical distance from the corner of the image (71) of the object (8), for detecting the inclination of the object (8) (Figs. 10, 11, 12).

6. Apparatus as claimed in claim 1, 2, 3 or 4, operable to scan an image of the object, for example slantwise, beginning at at least two different corners or a rectangular image area (ABCD), thereby to detect at least two corners (C1, C2) of the image of the object, for detecting the inclination of the object (Figs. 17A, 17B).

7. Apparatus as claimed in claim 1, 2 or 3, operable to subject a plurality of templet patterns (Fig. 18A), corresponding each to at least one part of the profile or outline of the object, to pattern matching (Fig. 18B) with an image of the object.

8. Apparatus according to claim 1, 2 or 3, operable to scan an image (71) of the object along a first pair of parallel lines (a, b), and along a second pair of parallel lines (c, d), which second pair of lines intersects with the first pair of lines at right angles (fig. 20).

9. Apparatus as claimed in any preceding claim, operable to project an image ($P_1'$) of the pattern onto X and Y axes, for forming X and Y axis projections of the image, numbers of consecutive image-representing data values exceeding, or failing to reach, a selected threshold value being counted from one end of a projection to the other, the threshold value being adjusted until the said number is found to correspond to a length at least equal to a pre-determined width of the pattern, and a point corresponding to the middle point of that part of the projection to which the said number corresponds is detected, thereby to determine the width of the pattern and the position of the centre of the pattern (Figs. 14A, 14B).

10. Apparatus as claimed in claim 3 or any one of claims 4 to 9 when read as appended to claim 3, wherein phe size of a picture element represented by a unit of data used for detecting the position and inclination of the object differs from the size of a picture element represented by such a unit of data used for detecting the position of the pattern.

11. Apparatus as claimed in claim 1, wherein the said image pickup section is constituted by a first optical system (B, 181) for picking up an image of the object and a second optical system (A, 182) for picking up an image of the pattern (Fig. 21).

12. Apparatus as claimed in claim 11, wherein the object (8) is a semiconductor device which is placed on a substrate (200) of the apparatus, which substrate has a rough surface, and the first optical system (181) is provided with a diaphragm (201) in the Fourier transform plane (Fig. 23).

13. Apparatus as claimed in claim 11, wherein the object (8) is a semiconductor device, having a wiring pattern thereon, and the wiring pattern is aligned with the second optical system, whereby the position of the pattern is detected, using data obtained by the first optical system and representing the position of the semiconductor device (Fig. 21).

14. Apparatus as claimed in claim 11, wherein the first and second optical systems constitute a single pickup device which picks up two images of the one object, the two images being obtained at different respective magnifying powers (Figs. 25A, 25B, 26A, 26B).

15. Apparatus according to claim 14, wherein the magnifying powers are determined electrically (Figs. 26A, 26B).

16. Apparatus according to claim 11, wherein the first and second optical systems constitute a single image pickup device (230) which image pickup device is operable to pickup from its image pickup region a plurality of images obtained at different respective magnifying powers (Figs. 27A, 27B).

**Patentansprüche**

1. Positionserkennungsvorrichtung, mit einem Bildaufnahmeabschnitt (3) zur Abbildung eines Objekts (8) und eines Musters (9) auf dem Objekt; dadurch gekennzeichnet, daß die Vorrichtung umfaßt, Einrichtungen (4) zum Wandeln der Bildsignale, die von dem Bildaufnahmeabschnitt (3) ausgegeben werden und einem vorbestimmten Feld des Gesichtsfelds entsprechen, in erste binär codierte Signale, die Bildsignalen entsprechen, welche einen ersten Schwellenwert überschriten, der zur Unterscheidung des Objekts ·(8) geeignet ist, Einrichtungen (5) zur Erkennung der absoluten Position und Neigung des Objektes (8) auf der Basis der ersten binär codierten Signale; Einrichtungen (6) zum Wandeln von Bildsignalen, welche von dem Bildaufnahmeabschnitt (3) ausgegeben werden, welche lediglich einem Sichtfenster entsprechen, das kleiner als das vorbestimmte Gesichtsfeld und innerhalb desselben angeordnet, ist, in zweite binär codierte Signale, die den Bildsignalen entsprechen, die einen zweiten Schwellenwert überschreiten, der geeignet ist, das Muster (9) zu unterscheiden, und Einrichtungen (7) zur Erkennung der absoluten Position eines Musters (9) auf der Basis der zweiten binär codierten Signale.

2. Vorrichtung nach Anspruch 1, ferner mit

einer Einrichtung (6) zur Berechnung der Position des sichtfensters aus Daten, die die absolute Position un Nei-gung des Objekts (8) darstellen, und aus Daten, die die relative Position des Musters (9) in Bezug auf das Objekt darstellen.

3. Vorrichtung nach Anspruch 1 oder 2, bei welcher die Position des Objekts (8) bei einer relativ niedrigen Auflösung erkannt wird und die Position des Musters (9) bei einer relativ höberen Auflösung erkannt wird.

4. Vorrichtung nach Anspruch 1, 2 oder 3, die ein Bild (71) eines Objektes (8) in schräger Weise abtasten kann, beginnend an einer Ecke eines rechtwinkligen Bildbereichs (ABCD), um dadurch die Adresse der Ecke des Objekts (Figuren 8A, 8B, 9) zu erkennen.

5. Vorrichtung nach Anspruch 1, 2, 3 oder 4, die ein Bild (71) des Objektes (8) längs einer vertikalen Linie abtasten kann, die durch einen Punkt in einem vorbestimmten horizontalen Abstand von einer Ecke des Bildes (71) des Objekts (8) hindurchtritt, und/oder längs einer horizontalen Linie, die durch einen Punkt in einem vorbestimmten vertikalen Abstand von der Ecke des Bildes (71) des Objekts (8) verläuft, um die Neigung des Objekts (8) (Figuren 10, 11, 12) zu erkennen.

6. Vorrichtung nach Anspruch 1, 2, 3 oder 4, die ein Bild eines Objektes, zum Beispiel in schräger Weise, abtasten kann, beginnend an wenigstens zwei verschiedenen Ecken eines rechtwinkligen Bildbereichs (ABCD) um dadurch wenigstens zwei Ecken (C1, C2) des Bildes des Objektes zu erkennen, um die Neigung des Objektes (Figuren 17A, 17B) zu erkennen.

7. Vorrichtung nach Anspruch 1, 2 oder 3, die eine Vielzahl von Schablonenmustern (Figur 18A), die jeweils wenigstens einem Teil des Profils oder des Umrisses eines Objektes entsprechen, einer Musterübereinstimmung (Figur 18B) mit einem Bild des Objektes unterwerfen kann.

8. Vorrichtung nach Anspruch 1, 2 oder 3, die ein Bild (71) eines Objekts längs einem ersten Paar von parallelen Linien (a, b) und längs einem zweiten Paar von parallelen Linien (c, d) abtasten kann, welches zweite Paar von Linien das erste Paar von Linien rechtwinklig schneidet (Figur 20).

9. Vorrichtung nach einem der vorhergehenden Ansprüche, welche eine Bilde (P1') des Musters auf X- und Y-Achsen projizieren kann, um X- und Y-Achsprojektionen des Bildes zu bilden, wobei Zahlen von aufeinanderfolgenden bilddarstellenden Datenwerten, die einen ausgewählten Schwellenwert überschreiten, oder diesen nicht erreichen, von einem einer Projektion zu dem anderen gezählt werden, wobei der Schwellenwert eingestellt wird, bis die genannte Zahl gefunden ist, um einer Länge von wenigstens einer vorbestimmten Breite des Musters zu entsprechen, und ein Punkt, der dem mittleren Punkt von demjenigen Teil von der Projektion entspricht, dem die genannte Zahl entspricht, erkannt wird, um dadurch die Breite des Musters und die Position des Zentrums des Musters (Figur 14A, 14B) zuerkennen.

10. Vorrichtung nach Anspruch 3 oder einem der Ansprüche 4 bis 9 in Verbindung mit Anspruch 3, bei welchem die Größe eines Bildelements, das durch eine Einheit von Daten, die zur Erkennung der Position und der Neigung des Objekts verwendet werden, dargestellt wird, von der Größe eines Bildelementes abweicht, das durch solch eine Einheit von Daten dargestellt wird, die zur Erkennung der Position des Musters verwendet werden.

11. Vorrichtung nach Anspruch 1, bei welcher der genannte Bildaufnahmeabschnitt von einem ersten optischen System (B, 181) sur Aufnahme eines Bildes des Objektes und einem zweiten optischen System (A, 182) zur Aufnahme eines Bildes des Musters (Figur 21) gebildet ist.

12. Vorrichtung nach Anspruch 11, bei welcher das Objekt (8) eine Halbleitervorrichtung ist, die auf eine Substrat (200) der Vorrichtung plaziert ist, welches Substrat eine rauhe Oberfläche hat, und das erste optische System (181) ein Diaphragma (201) in der Fourier - Transformationsebene (Figur 23) hat.

13. Vorrichtung nach Anspruch 11, bei welcher das objekt (8) eine Halbleitervorrichtung ist, welche ein Verdrahtungsmuster trägt, und das Verdrahtungsmuster mit dem zweiten optischen System ausgerichtet ist, wodurch die Position des Musters erkannt wird, unter Verwendung von Daten, die durch das erste optische System gewonnen werden und die Position der Halbleitervorrichtung (Figur 21) darstellen.

14. Vorrichtung nach Anspruch 11, bei welcher das erste und das zweite optische System eine einzige Aufnahmevorrichtung bilden, welche zwei Bilder von einem Objekt aufnimmt, wobei die beiden Bilder mit jeweils verschiedenen Vergrößerungsfaktoren (Figuren 25A, 25B, 26A, 26B) erhalten werden.

15. Vorrichtung nach Anspruch 14, bei welcher die Vergrößrungsfaktoren elektrisch bestimmt werden (Figuren 26A, 26b).

16. Vorrichtung nach Anspruch 11, bei welcher das erste und das zweite optische System eine einzige Bildaufnahmevorrichtung (230) bilden, die von ihrem Bildaufnahmebereich eine Vielzahl von Bildern, die mit entsprechend verschiedenen Vergrößerungsfaktoren (Fig. 27A, 27B) erhalten werden, aufnehmen kann.

**Revendications**

1. Appareil de reconnaissance de position comportant une section de prise vues (3) pour former une image d'une objet (8) et d'une configuration (9) sur l'objet, appareil caractérisé en ce qu'il comporte un dispositif (4) destiné à convertir des signaux d'images émis par la section de prise de vues (3) et correspondant à un champ de vision prédéterminé en des premiers signaux en code binaire correspondant à des signaux d'images dépassant une première valeur seuil qui convient pour distinguer l'objet (8), un dispositif (5) destiné à détecter la position et l'inclinaison absolues de l'objet (8) sur la base des premiers signaux en code binaire, un dispositif (6) de conversion des signaux d'images émis par la section de prise de vues (3) correspondant seulement à une fenêtre d'observation plus petite que la champ de vision prédéterminé et à l'intérieur de ce dernier en des seconds signaux en code binaire correspondant à des signaux d'images dépassant une seconde valeurseuil qui convient pour distinguer le configuration, et un dispositif (7) destiné à détecter la position absolue de la configuration (9) sur la base des seconds signaux en code binaire.

2. Appareil selon la revendication 1, comportant en outre un dispositif (6) destiné à calculer la position de la fenêtre d'observation à partir de données représentant la position et l'inclinaison absolues de l'objet (8) et de données représentant la position relative de la configuration (9) par rapport à l'objet.

3. Appareil selon la revendication 1 ou 2, dans lequel la position de l'objet (8) est détectée à une résolution relativement inférieure et la position de la configuration (9) est détectée avec une résolution relativement supérieure.

4. Appareil selon la revendication 1, 2 ou 3, fonctionnant en balayant de façon inclinée une image (71) de l'objet (8) en commençant par un angle d'un surface d'images rectangulaire ABCD de manière à détecter l'adresse d'un angle de l'objet (figures 8A, 8B, 9).

5. Appareil selon la revendication 1, 2, 3 ou 4 balayant une image (71) de l'objet (8) le long d'une ligne vertivale passant par un point à une distance horizontale prédéterminée d'un angle de l'image (71) de l'objet (8) et/ou le long d'une horizontal passant par un point à une distance verticale prédéterminée de l'angle de l'image (71) de l'objet (8) pour détecter l'inclinaison de l'objet (8) (figures 10, 11, 12).

6. Appareil selon la revendication 1, 2, 3 ou 4 balayant une image de l'objet, par exemple de façon inclinée, en commençant par au moins deux angles différents d'une surface d'images rectangulaires ABCD de manière à détecter au moins deux angles $C_1$, $C_2$ de l'imge de l'objet pour détecter l'inclinaison de cet objet (figure 17A, 17B).

7. Appareil selon la revendication 1, 2 ou 3, ayant pour fonction de soumettre plusierurs configurations de gabarit (Figure 18A) correspondant chacun à au moins une partie du profile ou du contour de l'objet à une adaptation de configuration (figure 18B) avec une image de l'objet.

8. Appareil selon la revendication 1, 2 ou 3, balayant une image (71) de l'objet le long d'une première paire de lignes parallèles (a, b) et le long d'une seconde paire de lignes parallèles (c, d), la seconde paire de lignes coupant la première paire de lignes à angle droit (Figure 20).

9. Appareil selon l'une quelconque des revendications précédentes, agencé de manière à projeter une image ($P'_1$) de la configuration sur des axes (X et Y) pour former des projections d'axe (X et Y) l'image, des nombres de valeurs de données représentant l'image dépassant ou n'atteignant pas une valeur seuil sélectionnée é6ant comptés à partir d'une extrémité d'une projection vers l'autre, la valeur seuil étant règlée jusqu'à ce qu'il apparaisse que ledit nombre correspond à une longueur au moins égale à une largeur prédéterminée de la configuration, et un point correspondant au point milieu de cette partie de la projection à laquelle correspond ledit nombre est détecté de manière à déterminer la largeur de la configuration et la position de centre de cette configuration (figures 14A, 14B).

10. Appareil selon la revendication 3 ou l'une quelconque des revendications 4 à 9, lues comme annexes à la revendication 3, dans lequel la dimension d'un élément d'images représenté par une unité de données utilisée pour détecter la position et l'inclinaison de l'objet diffère de la dimension d'un élément d'images représenté par cette unité de données utilisée pour détecter la position de la configuration.

11. Appareil selon la revendication dans lequel ladite section de prise de vues est constituées par un premier système optique (B, 181) pour prendre une image de l'objet et un second système optique (A, 182) pour prendre une image de la configuration (figure 21).

12. Appareil selon la revendication 11, dans lequel l'objet (8) est un composant semiconducteur qui est placé sur un substrat (200) de l'appareil, le substrat ayant une surface rugueuse et le premier système optique (181) comportant un diaphragme (201) dans le plan de tranformée de Fourier (figure 23).

13. Appareil selon la revendication 11, dans lequel l'objet (8) est un composant semiconducteur comprenant une configuration de câblage, la configuration de câblage étant alignée avec le second système optique de manière que la position de la configuration soit détectée, en utilisant des données obtenues par le premier système optique et représentant la position du composant semiconducteur (figure 21).

14. Appareil selon la revendication 11, dans lequel le premier et le second systèmes optiques constituent un seul dispositif de prise de vues qui prend deux images de l'objet, les deux images étant obtenues avec des grossissements respectifs différents (figures 25A, 25B, 26A, 26B).

15. Appareil selon la revendication 14, dans lequel les grossissements sont déterminés électriquement (figure 26A, 26B).

16. Appareil selon la revendication 11, dans lequel le premier et le secons systèmes optiques constituent un seul dispositif de prise de vues (230) ce dispositif de prise de vues prenant dans sa région de prise d'images, plusieurs images obtenues avec des grossissements respectifs différents (figure 27A et 27B).

**0 041 870**

FIG.1

FIG.2A

FIG.2B

FIG.2C

FIG.2D

1

FIG.3A

DC    THRESHOLD VALUE

COMP.

| TV CAMERA | DRIVER |

PAD BINARY CODED SIGNAL

14    17

COMP.

15    18

CHIP BINARY CODED SIGNAL

13    16

THRESHOLD VALUE    DC

FIG.3B

TV SCANNING LINE

9    19

FIG.3C

2nd THRESHOLD VALUE

1st THRESHOLD VALUE

FIG.3D

"1"
"0"    PAD IMAGE BINARY CODED SIGNAL

"1"
"0"    CHIP IMAGE BINARY CODED SIGNAL

2

FIG. 4

RELATIVE ADDRESS
BETWEEN CHIP AND PAD

IMAGE SIGNAL — 21

BINARY CODED SIGNAL
TREATMENT

WINDOW
SIZE        26    25

CHIP IMAGE
DETECT         23

VIEW
WINDOW
DETECT         24

PAD
PATTERN         27
DETECT

PAD POSITION         28
DETECT

FIG. 5

FIG.6

MEMORY READ OUT CIRCUIT

FIG.7

FIG.8A

FIG.8B

FIG.9

BUS LINE 30

CONTROL REGISTER

DESIGNATING REGISTER

80

81

DECODER

86

82 UPPER-LEFT INITIAL VALUE REGISTER

83 UPPER-RIGHT INITIAL VALUE REGISTER

84 LOWER-LEFT INITIAL VALUE REGISTER

85 LOWER-RIGHT INITIAL VALUE REGISTER

END

START

START

87 ( X SCANNING →) 97

START POINT COUNTER X REG. 99 COMP

88 TERMINAL POINT ADDRESS X REG. END START

(Y SCANNING ↓) 98

START POINT COUNTER Y REG. COMP

89 TERMINAL POINT ADDRESS Y REG. 100 END START

90

START

SLANTWISE SCANNING X STOP

SLANT COUNTER X

91 SLANT TERMINAL ADDRESS X REG. COMP END 95

92

93 96

SLANT COUNTER Y

SLANT TERMINAL ADDRESS Y REG. 94 COMP END

CORNER DETECTION

SCANNING ADDRESS X

SCANNING ADDRESS Y

READ OUT CIRCUIT

0 041 870

FIG.10                    FIG.11

FIG.12

FIG.13

FIG.14A

FIG.14B

FIG. 15

FIG.16

FIG.17A

FIG.17B

FIG.18A

FIG.18B

$C_1-\theta$     $C_1+O$     $C_1+\theta$

$C_2-\theta$     $C_2+O$     $C_2+\theta$

$C_1-\theta$

C

71

FIG. 19

C-θ            Co            C+θ

F I G. 20

FIG. 21

FIG. 22A

FIG.22B

FIG. 22C

FIG.22D

FIG.22E

FIG. 23

FIG. 24

FIG. 25A    FIG. 25B

FIG. 26A

FIG. 26B

220

8

512 BITS

512 BITS

256

256

256

256

222

221

FIG. 26C

226

223 — TV IMAGE SIGNAL

COMPARATOR

224

MEMORY CONTROLLER

FRAME MEMORY

SAMPLING CLOCK GENERATOR

225

227

45

FIG.27A　　　FIG.27B

230

231　　232

8

233

234